# EUROPEAN PATENT APPLICATION

(11) **EP 3 133 811 A1**
(43) Date of publication of application: **22.02.2017**
(21) Application number: 15780031.9
(22) Date of filing: 03.04.2015
(51) Int. Cl.: H04N 9/04, H01L 27/146, H04N 5/33

(54) **IMAGE SENSOR AND MONITORING SYSTEM**

(30) Priority: 13.04.2014 CN 201410146621
(71) Applicant: BYD Company Limited, Shenzhen 518118 (CN)
(72) Inventor: FENG, Wei, Shenzhen Guangdong 518118 (CN); CHEN, Zengqiang, Shenzhen Guangdong 518118 (CN); FU, Jingjun, Shenzhen Guangdong 518118 (CN)
(74) Representative: Haseltine Lake LLP
(86) International application number: PCT/CN2015/075875
(87) International publication number: WO 2015/158211

(57) **Abstract**

The present invention proposes an image sensor, a monitoring system and a method for designing an image sensor, the image sensor including: a color filter, wherein, for light in infrared wavebands, the color filter only allows particular-wavelength infrared light to pass, and the color filter includes multiple n-color filters, wherein each filter corresponds to one color, the multiple n-color filters are used for dividing visible light in incident light into n-color light; and a light-sensitive chip, including a signal processing circuit and multiple light-sensitive units, the multiple light-sensitive units are respectively used for sensing intensity of light transmitting through the multiple n-color filters and generating electric signals corresponding to the light transmitting through the multiple n-color filters, the signal processing circuit is used for processing the electric signals for imaging, wherein a gain ratio of the signal processing circuit to the electric signals is A1: A2: ...: Ai: ...: Aj: ...: An, wherein an intensity transmittance of the multiple n-color filters to the particular-wavelength infrared light is M1: M2(A1/A2): ...: Mi(A1/Ai): ...: Mj(A1/Aj): ...: Mn(A1/An). The image sensor of the present invention increases an application range of the image sensor by adjusting optical characteristics of the color filter to achieve color cast desired by a user.

## Description

### BACKGROUND

### Technical Field

The present invention relates to the field of image imaging technologies, and particularly to an image sensor and a monitoring system.

### Related Art

As a typical solid imaging sensor, a Complementary Metal-Oxide-Semiconductor Transistor (CMOS) image sensor can be applied to many fields. As the CMOS image sensor has advantages of low cost and easy integration, the CMOS image sensor has been widely applied currently in digital products such as digital cameras and digital video cameras. However, for color cast generated in the outside, the current CMOS image sensor mainly conducts filtering by increasing an external cut-off filter, which not only increases the cost of the CMOS image sensor but also reduces reliability of the CMOS image sensor. For example, when infrared light exists in an application environment of the CMOS image sensor, the infrared light will affect color cast of the CMOS image sensor, and the color cast is relatively simple. Therefore, when incident light has visible light and infrared light at the same time, and when a user hopes that the CMOS image sensor generates color cast or a color cast degree desired by the user, the current CMOS image sensor cannot achieve that, resulting in a narrower application range of the image sensor and poor user experience.

### SUMMARY

The present invention is aimed at at least solving one of the above technical defects.

To this end, a first objective of the present invention is to propose one image sensor. The image sensor achieves user-desired color cast or color cast degree by adjusting optical characteristics of a color filter, thus greatly increasing an application range of the image sensor and enhancing user experience.

A second objective of the present invention is to propose one monitoring system.

A third objective of the present invention is to propose another image sensor.

A fourth objective of the present invention is to propose another monitoring system.

A fifth objective of the present invention is to propose another image sensor.

A sixth objective of the present invention is to propose another monitoring system.

A seventh objective of the present invention is to propose another image sensor.

An eighth objective of the present invention is to propose another monitoring system.

To achieve the above objective, an image sensor according to an embodiment in a first aspect of the present invention includes: a color filter, wherein, for light in infrared wavebands, the color filter is arranged to allow a particular-wavelength infrared light to pass, and the color filter includes multiple n-color filters, wherein each of the multiple n-color filters corresponds to a color, the multiple n-color filters are arranged to divide visible light in incident light into n-color light, wherein n is a positive integer; and a light-sensitive chip located below the color filter, wherein the light-sensitive chip includes a signal processing circuit and multiple light-sensitive units one-to-one corresponding to the multiple n-color filters, the multiple light-sensitive units are respectively arranged to sense intensity of light transmitting through the multiple n-color filters and generate electric signals corresponding to the light transmitting through the multiple n-color filters, the signal processing circuit is configured to process the electric signals for imaging, wherein a gain ratio of the signal processing circuit to the electric signals is A1: A2: ...: Ai: ...: Aj: ...: An, wherein i and j are integers greater than or equal to 1 and less than or equal to n, and i≠j, wherein an intensity transmittance of the multiple n-color filters of the color filter to the particular-wavelength infrared light is M1: M2(A1/A2): ...: Mi(A1/Ai): ...: Mj(A1/Aj): ...: Mn(A1/An), and values of the M1, M2, ..., Mi, ..., Mj, ... and Mn are determined according to color cast required by the image sensor.

The image sensor according to the embodiment of the present invention achieves user-desired color cast or color cast degree by adjusting optical characteristics of a color filter, thus greatly increasing an application range of the image sensor and enhancing user experience.

To achieve the above objective, a monitoring system according to an embodiment in a second aspect of the present invention includes an electronic device, wherein the electronic device includes the image sensor according to the embodiment in the first aspect of the present invention; and a fill light lamp, wherein the fill light lamp emits the particular-wavelength infrared light.

The monitoring system according to the embodiment of the present invention can achieve user-desired color cast or color cast degree, thus greatly increasing an application range of the image sensor and enhancing user experience.

To achieve the above objective, an image sensor according to an embodiment in a third aspect of the present invention includes: at least one light filter for filtering a particular-wavelength infrared light, wherein the at least one light filter allows visible light and the particular-wavelength infrared light to transmit; a color filter located below the at least one light filter, wherein the color filter includes multiple n-color filters, wherein each of the multiple n-color filters corresponds to a color, the multiple n-color filters are used for dividing visible light in incident light into n-color light, wherein n is a positive integer; and a light-sensitive chip located below the color filter, wherein the light-sensitive chip includes a signal processing circuit and multiple light-sensitive units one-to-one corresponding to the multiple n-color filters, the multiple light-sensitive units are respectively arranged to sense intensity of light transmitting through the multiple n-color filters and to generate electric signals corresponding to the light transmitting through the multiple n-color filters, the signal processing circuit is configured to process the electric signals for imaging, and a gain ratio of the signal processing circuit to the electric signals is A1: A2: ...: Ai: ...: Aj: ...: An, wherein i and j are integers greater than or equal to 1 and less than or equal to n, and i≠j, wherein an intensity transmittance of the multiple n-color filters of the color filter to the particular-wavelength infrared light is M1: M2(A1/A2): ...: Mi(A1/Ai): ...: Mj(A1/Aj): ...: Mn(A1/An), and values of M1, M2, ..., Mi, ..., Mj, ... and Mn are determined according to color cast required by the image sensor.

The image sensor according to the embodiment of the present invention achieves user-desired color cast or color cast degree by adjusting optical characteristics of a color filter and using a light filter having particular optical characteristics, thus greatly increasing an application range of the image sensor and enhancing user experience.

To achieve the above objective, a monitoring system according to an embodiment in a fourth aspect of the present invention includes an electronic device, wherein the electronic device includes the image sensor according to the embodiment in the third aspect of the present invention; and a fill light lamp, wherein the fill light lamp emits the particular-wavelength infrared light.

The monitoring system according to the embodiment of the present invention can achieve user-desired color cast or color cast degree, thus greatly increasing an application range of the image sensor and enhancing user experience.

To achieve the above objective, an image sensor according to an embodiment in a fifth aspect of the present invention includes a color filter, wherein, for light in infrared wavebands, the color filter is arranged to allow a particular-wavelength infrared light to pass, and the color filter includes multiple n-color filters, wherein each of the multiple n-color filters corresponds to one color, the multiple n-color filters are arranged to divide visible light in incident light into n-color light, wherein n is a positive integer; and a light-sensitive chip located below the color filter, wherein the light-sensitive chip includes a signal processing circuit and multiple light-sensitive units one-to-one corresponding to the multiple n-color filters, the multiple light-sensitive units are respectively used for sensing intensity of light transmitting through the multiple n-color filters and generating electric signals corresponding to the light transmitting through the multiple n-color filters, the signal processing circuit is configured to process the electric signals for imaging, wherein a gain ratio of the signal processing circuit to the electric signals is M1A1: M2A2: ...: MiAi: ...: MjAj: ...: MnAn, and values of the M1, M2, ..., Mi, ..., Mj, ... and Mn are determined according to color cast required by the image sensor, wherein i and j are integers greater than or equal to 1 and less than or equal to n, and i≠j, wherein an intensity transmittance of the multiple n-color filters of the color filter to the particular-wavelength infrared light is 1: (A1/A2): ...: (A1/Ai): ...: (A1/Aj): ...: (A1/An).

The image sensor according to the embodiment of the present invention achieves user-desired color cast or color cast degree by adjusting optical characteristics of a color filter, thus greatly increasing an application range of the image sensor and enhancing user experience.

To achieve the above objective, a monitoring system according to an embodiment in a sixth aspect of the present invention includes an electronic device, wherein the electronic device includes the image sensor according to the embodiment in the fifth aspect of the present invention; and a fill light lamp, wherein the fill light lamp emits the particular-wavelength infrared light.

The monitoring system according to the embodiment of the present invention can achieve user-desired color cast or color cast degree, thus greatly increasing an application range of the image sensor and enhancing user experience.

To achieve the above objective, an image sensor according to an embodiment in a seventh aspect of the present invention includes at least one light filter, and arranged to filter a particular-wavelength infrared light, wherein the at least one light filter allows visible light and the particular-wavelength infrared light to transmit; a color filter located below the at least one light filter, wherein the color filter includes multiple n-color filters, wherein each filter corresponds to one color, the multiple n-color filters are arranged to divide visible light in incident light into n-color light, wherein n is a positive integer; and a light-sensitive chip located below the color filter, wherein the light-sensitive chip includes a signal processing circuit and multiple light-sensitive units one-to-one corresponding to the multiple n-color filters, the multiple light-sensitive units are respectively arranged to sense intensity of light transmitting through the multiple n-color filters and generating electric signals corresponding to the light transmitting through the multiple n-color filters, the signal processing circuit is configured to process the electric signals for imaging, wherein a gain ratio of the signal processing circuit to the electric signals is M1A1: M2A2: ...: MiAi: ...: MjAj: ...: MnAn, and values of the M1, M2, ..., Mi, ..., Mj, ... and Mn are determined according to color cast required by the image sensor, wherein i and j are integers greater than or equal to 1 and less than or equal to n, and i≠j, and an intensity transmittance of the multiple n-color filters of the color filter to the particular-wavelength infrared light is 1: (A1/A2): ...: (A1/Ai): ...: (A1/Aj): ...: (A1/An).

The image sensor according to the embodiment of the present invention achieves user-desired color cast or color cast degree by adjusting optical characteristics of a color filter and using a light filter having particular optical characteristics, thus greatly increasing an application range of the image sensor and enhancing user experience.

To achieve the above objective, a monitoring system according to an embodiment in an eighth aspect of the present invention includes an electronic device, wherein the electronic device includes the image sensor according to the embodiment in the seventh aspect of the present invention; and a fill light lamp, wherein the fill light lamp emits the particular-wavelength infrared light.

The monitoring system according to the embodiment of the present invention can achieve user-desired color cast or color cast degree, thus greatly increasing an application range of the image sensor and enhancing user experience.

Additional aspects and advantages of the present invention will be partially given in the following description, and some will become evident from the following description or understood through practice of the present invention.

### BRIEF DESCRIPTION OF THE DRAWINGS

The aforementioned and/or additional aspects and advantages of the present invention will become evident and easy to understand from the following description about embodiments with reference to the accompanying drawings, and wherein:
FIG. 1 is a schematic structural diagram of an image sensor according to one embodiment of the present invention;
FIG. 2 is a schematic diagram of an image sensor according to one embodiment of the present invention;
FIG. 3 is a schematic diagram showing that red, green and blue light-sensitive units sense light according to one embodiment of the present invention;
FIG. 4(1) is a schematic diagram of optical characteristics of a red filter before adjustment according to one embodiment of the present invention;
FIG. 4(2) is a schematic diagram of optical characteristics of a green filter before adjustment according to one embodiment of the present invention;
FIG. 4(3) is a schematic diagram of optical characteristics of a blue filter before adjustment according to one embodiment of the present invention;
FIG. 5(1) is a schematic diagram of optical characteristics of a red filter after adjustment according to one embodiment of the present invention;
FIG. 5(2) is a schematic diagram of optical characteristics of a green filter after adjustment according to one embodiment of the present invention;
FIG. 5(3) is a schematic diagram of optical characteristics of a blue filter after adjustment according to one embodiment of the present invention;
FIG. 6(1) is a schematic structural diagram of an image sensor according to another embodiment of the present invention;
FIG. 6(2) is a schematic structural diagram of an image sensor according to a yet another embodiment of the present invention;
FIG. 6(3) is a schematic structural diagram of an image sensor according to a further embodiment of the present invention;
FIG. 7 is a schematic structural diagram of a monitoring system according to one embodiment of the present invention;
FIG. 8 is a schematic structural diagram of an image sensor according to another embodiment of the present invention;
FIG. 9 is a schematic diagram of optical characteristics of a light filter 500 according to one embodiment of the present invention;
FIG. 10(1) is a schematic diagram of optical characteristics of a red filter according to one embodiment of the present invention;
FIG. 10(2) is a schematic diagram of optical characteristics of a green filter according to one embodiment of the present invention;
FIG. 10(3) is a schematic diagram of optical characteristics of a blue filter according to one embodiment of the present invention;
FIG. 11 is a schematic structural diagram of an image sensor according to another embodiment of the present invention;
FIG. 12 is a schematic structural diagram of a monitoring system according to another embodiment of the present invention;
FIG. 13 is a schematic structural diagram of an image sensor according to one embodiment of the present invention;
FIG. 14(1) is a schematic structural diagram of an image sensor according to another embodiment of the present invention;
FIG. 14(2) is a schematic structural diagram of an image sensor according to yet another embodiment of the present invention;
FIG. 14(3) is a schematic structural diagram of an image sensor according to a further embodiment of the present invention;
FIG. 15 is a schematic structural diagram of a monitoring system according to one embodiment of the present invention;
FIG. 16 is a schematic structural diagram of an image sensor according to another embodiment of the present invention;
FIG. 17 is a schematic structural diagram of an image sensor according to a further embodiment of the present invention; and
FIG. 18 is a schematic structural diagram of a monitoring system according to another embodiment of the present invention.

### DETAILED DESCRIPTION

The embodiments of the present invention are described below in detail, and examples of the embodiments are illustrated in the drawings, wherein identical or similar reference signs represent identical or similar elements or elements having identical or similar functions all the time. The following embodiments described with reference to the drawings are exemplary and only used to explain the present invention, but cannot be understood as limitations to the present invention.

The disclosure hereinafter provides lots of different embodiments or examples to implement different structures of the present invention. In order to simplify the disclosure of the present invention, components and settings of specific examples are described hereinafter. Certainly, they are merely exemplary and are not intended to limit the present invention. In addition, the present invention may repeat reference numbers and/or letters in different examples. Such repetition is for simplification and clarity, which does not indicate relationships between various embodiments and/or settings discussed. In addition, the present invention provides examples of various specific processes and materials, but those of ordinary skill in the art can realize applicability of other processes and/or use of other materials. Besides, the structure described below in which the first feature is "above" the second feature may include an embodiment in which the first and second features form a direct contact, and may also include an embodiment in which another feature is formed between the first and second features, and thus the first and second features may not in direct contact.

In the description of the present invention, it should be noted that, unless otherwise explicitly stipulated and defined, the terms "install", "connected with" and "connect" should be understood in a broad sense, for example, it may be a mechanical connection or an electrical connection, communication inside two elements, a direct connection or a connection through an intermediate medium. For those of ordinary skill in the art, the specific meanings of the terms can be understood according to specific situations.

Image sensors and monitoring systems according to embodiments of the present invention are described below with reference to the accompanying drawings.

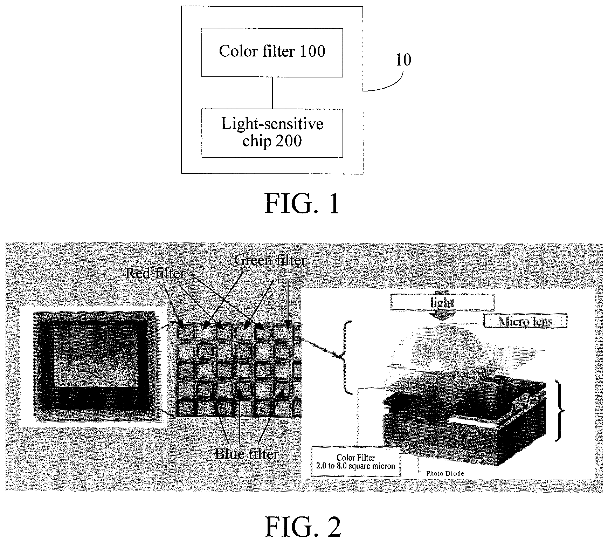

FIG. 1 is a schematic structural diagram of an image sensor according to one embodiment of the present invention. The image sensor according to the embodiment of the present invention is a CMOS image sensor. As shown in FIG. 1, the image sensor 10 includes: a color filter 100, and a light-sensitive chip 200.

For visible light, the color filter 100 allows part of the visible light to transmit; for infrared wavebands, the color filter 100 only allows particular-wavelength infrared light to pass, an intensity transmittance of the color filter 100 to the particular-wavelength infrared light is adjustable, and the color filter 100 includes multiple n-color filters, wherein each filter corresponds to one color, the multiple n-color filters are used for dividing visible light in incident light into n-color light, wherein n is a positive integer. For visible light, the color filter 100 allows part of the visible light to transmit, which means that the color filter 100 includes multiple-color filters, for example, when the color filter 100 includes red, green and blue filters, the red filter only allows red light in the visible light to transmit, the green filter only allows green light in the visible light to transmit, and the blue filter only allows blue light in the visible light to transmit.

The light-sensitive chip 200 is located below the color filter 100, the light-sensitive chip 200 includes a signal processing circuit and multiple light-sensitive units one-to-one corresponding to the multiple n-color filters, the multiple light-sensitive units are respectively used for sensing intensity of light transmitting through the multiple n-color filters and generating electric signals corresponding to the light transmitting through the multiple n-color filters, the signal processing circuit is used for processing the electric signals for imaging, and a gain ratio of the signal processing circuit to the electric signals is A1: A2: ...: Ai: ...: Aj: ...: An, wherein i and j are integers greater than or equal to 1 and less than or equal to n, and i≠j, wherein an intensity transmittance of the multiple n-color filters of the color filter to the particular-wavelength infrared light is M1: M2(A1/A2): ...: Mi(A1/Ai): ...: Mj(A1/Aj): ...: Mn(A1/An), and values of the M1, M2, ..., Mi, ..., Mj, ... and Mn are determined according to color cast required by the image sensor.

In one embodiment of the present invention, the color cast includes a color cast type. For example, a shot picture is redish, greenish or blueish in color.

In one embodiment of the present invention, the color cast further includes a color cast degree.

In one embodiment of the present invention, the Mi value of a filter corresponding to a target color cast type is greater than the Mj value of other filters.

For ease of description, the image sensor proposed in the present invention is described through examples. Specifically, description is given by taking that n=3 and the color filter 100 includes red, green and blue filters as an example. Herein, it should be noted that, that the color filter 100 includes red, green and blue filters is merely an example made for facilitating description, the color filter 100 may further include filters in other colors, for example, the color filter 100 may include cyan, carmine (or magenta) and yellow filters, and the color filter 100 may include red, green, blue and white filters.

Specifically, after being converged and strengthened by the micro lens, the light reaches the color filter 100 (which can be abbreviated as CF) which has light transmission selectivity (that is, only particular light is allowed to pass) and intensity attenuation (that is, intensity of passing light may decrease). The color filter 100 includes multiple red, green and blue filters used for dividing visible light in incident light into three primary colors, red, green and blue, and for infrared light wavebands, the red, green and blue filters only allow particular-wavelength infrared light (e.g., infrared light whose wavelength is 850 nm+-50 nm) to pass. Then, the multiple light-sensitive units are respectively used for sensing intensity of light transmitting through the multiple n-color filters and generating electric signals corresponding to the light transmitting through the multiple n-color filters, and the signal processing circuit is used for processing the electric signals for imaging. The light-sensitive units may be photosensitive diodes.

FIG. 2 is a schematic diagram of an image sensor. In FIG. 2, light indicates the incident light, Micro Lens is the micro lens, Color Filter is the color filter 100, and Photo Diode is the photosensitive diode, used for sensing light and converting light signals to electric signals. As shown in FIG. 2, red, green and blue filters are arranged in a certain order to form an array, for example, colors of filters from left to right in odd-numbered lines (e.g., Line 1, Line 3, Line 5) are sequentially red, green, red, green, red, green ..., and colors of filters from left to right in even-numbered lines (e.g., Line 2, Line 4) are sequentially green, blue, green, blue, green, blue ...

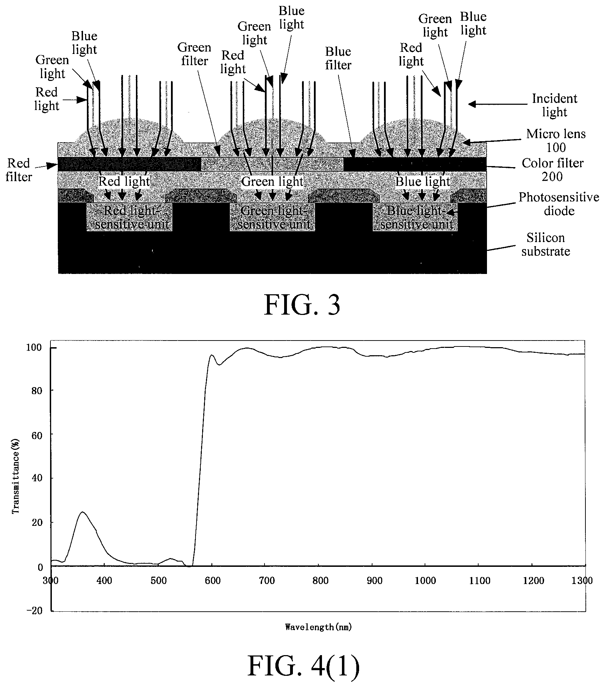

More specifically, the light-sensitive chip 200 conducts imaging according to light transmitting through the red, green and blue filters of the color filter 100. The signal processing circuit processes corresponding electric signals in an order of arrangement of the filters, to restore actual colors and form pictures. More specifically, the light transmitting through the red, green and blue filters of the color filter 100 passes through the photosensitive diodes, the light signals are converted to electric signals, and the electric signals can generate an image after being processed by the signal processing circuit. FIG. 3 is a schematic diagram showing that red, green and blue light-sensitive units sense light. The red, green and blue light-sensitive units one-to-one correspond to the red, green and blue filters.

In addition, in the embodiment of the present invention, the gain ratio of the signal processing circuit to the electric signals A1: A2: ...: Ai: ...: Aj: ...: An is obtained according to the intensity transmittance of the multiple n-color filters of the color filter to the particular-wavelength infrared light. As required by a picture to be formed, at first, the intensity transmittance of the multiple n-color filters of the color filter to the particular-wavelength infrared light is determined as M1: M2(A1/A2): ...: Mi(A1/Ai): ...: Mj(A1/Aj): ...: Mn(A1/An), wherein values of the M1, M2, ..., Mi, ..., Mj, ... and Mn are determined according to color cast required by the image sensor, next, in a testing process, the gain ratio of the signal processing circuit to the electric signals is determined according to the intensity transmittance of the multiple n-color filters of the color filter to the particular-wavelength infrared light, that is, the gain ratio of the signal processing circuit to the electric signals A1: A2: ...: Ai: ...: Aj: ...: An is obtained through testing.

Specifically, the red, green and blue filters are still taken as an example; in the sun, infrared light is filtered, and only visible light remains; at this point, the red, green and blue light-sensitive units sense intensity of the visible light, which is converted to electric signals and then will be processed by the signal processing circuit, and then an image in a pure color is output; at this point, the gain ratio of the signal processing circuit to the electric signals correspondingly generated by red, green and blue visible light is A1: A2: A3. Certainly, according to requirements, it is known to those skilled in the art that the red, green and blue visible light can be processed, to cause a component ratio of the red, green and blue visible light in the finally obtained image to be 1:1:1, thus obtaining an image whose color is the same as that of an actual object.

In one embodiment of the present invention, in a specific application environment of the image sensor, a fill light lamp can be selected to fill light for the image sensor, and the fill light lamp emits particular-wavelength infrared light.

In the embodiment of the present invention, the particular wavelength matches the wavelength of the infrared light emitted by the selected fill light lamp. Specifically, in a range of infrared wavebands, the color filter 100 only allows particular-wavelength infrared light to transmit, and other-wavelength infrared light cannot transmit through the color filter 100.

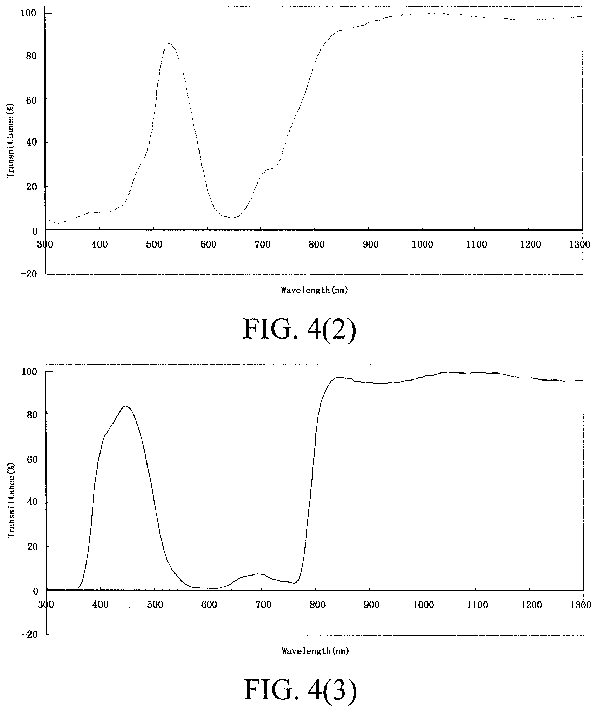

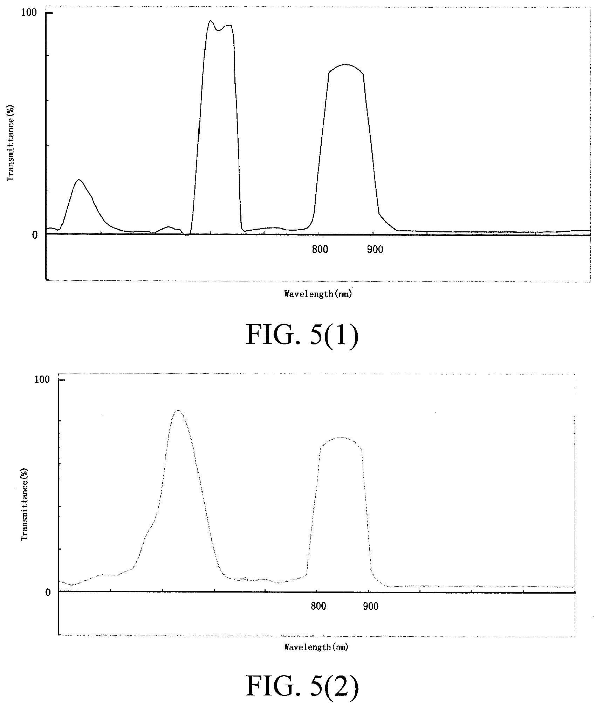

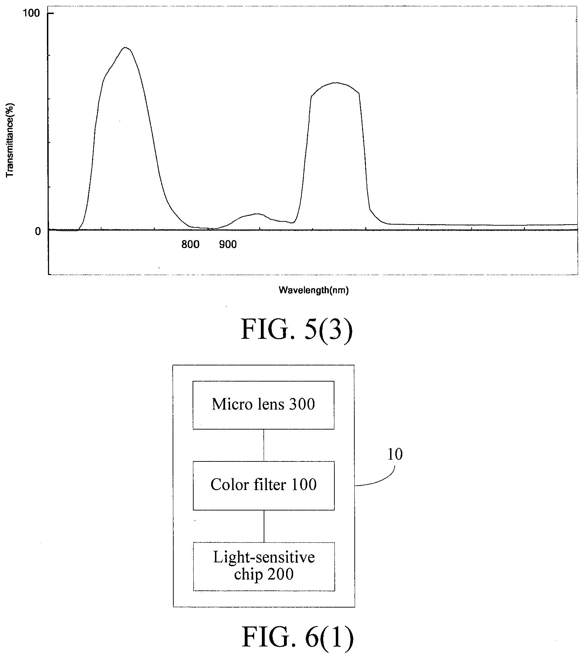

In the embodiment of the present invention, for example, in the evening, the wavelength of the infrared light emitted by the fill light lamp is λ (e.g., a fill light lamp of 850 nm+-50 nm is used). By adjusting optical characteristics of the CF in advance, only infrared light whose wavelength is λ (850 nm+-50 nm) can pass, while infrared light in other wavebands is cut off. The optical characteristics of the CF are as follows: optical characteristics of visible light wavebands remain unchanged, and in infrared light wavebands, infrared light with an infrared wavelength of λ (850 nm+-50 nm) used by the fill light lamp passes. At the same time, for the infrared light with a wavelength of λ (850 nm+-50 nm), the intensity transmittance of the multiple red, green and blue filters of the color filter 100 to the particular-wavelength (λ) infrared light is M1: M2(A1/A2): M3(A1/A3). FIG. 4(1) is a schematic diagram of optical characteristics of a red filter before adjustment, FIG. 4(2) is a schematic diagram of optical characteristics of a green filter before adjustment, FIG. 4(3) is a schematic diagram of optical characteristics of a blue filter before adjustment, FIG. 5(1) is a schematic diagram of optical characteristics of a red filter after adjustment, FIG. 5(2) is a schematic diagram of optical characteristics of a green filter after adjustment, and FIG. 5(3) is a schematic diagram of optical characteristics of a blue filter after adjustment.

Specifically, when the light-sensitive chip 200 senses a complicated spectral signal (visible light + infrared light), for the visible light, as the gain ratio of the signal processing circuit to the electric signals correspondingly generated by the light transmitting through the red, green and blue filters is A1: A2: A3, and at the same time, it is known to those skilled in the art that the red, green and blue visible light can be processed, to cause a component ratio of the red, green and blue visible light in the finally obtained image to be 1:1:1, so that the actual visible light color can be restored. For the infrared light, as the intensity transmittance of the multiple red, green and blue filters of the color filter 100 to the particular-wavelength (λ) infrared light is M1: M2(A1/A2): M3(A1/A3), when processed by the signal processing circuit, as the gain ratio of the signal processing circuit to the electric signals correspondingly generated by the light transmitting through the red, green and blue filters is A1: A2: A3, the infrared light is processed by the red, green and blue filters and the light-sensitive chip 200, and then the component ratio of red, green and blue colors under infrared in the obtained image is M1: M2: M3. Therefore, as long as the value of M1: M2: M3 is controlled in advance, color cast and the color cast degree of infrared light imaging can be controlled.

For example, when M1: M2: M3=1:1:1, when the light-sensitive chip 200 senses a complicated spectral signal (visible light + infrared light), for the visible light, as the gain ratio of the signal processing circuit to the electric signals correspondingly generated by the light transmitting through the red, green and blue filters is A1: A2: A3, and at the same time, it is known to those skilled in the art that the red, green and blue visible light can be processed, to cause a component ratio of the red, green and blue visible light in the finally obtained image to be 1:1:1, so that the actual visible light color can be restored. For the infrared light, as the intensity transmittance of the multiple red, green and blue filters of the color filter 100 to the particular-wavelength (λ) infrared light is 1: (A1/A2): (A1/A3), when processed by the signal processing circuit, as the gain ratio of the signal processing circuit to the electric signals correspondingly generated by the light transmitting through the red, green and blue filters is A1: A2: A3, the infrared light is processed by the red, green and blue filters and the light-sensitive chip 200, and then the component ratio of red, green and blue colors under infrared in the obtained image is 1:1:1; the ratio is gray scale of brightness, and thus incidence of the infrared light may not affect the restored color of the visible light. Moreover, due to addition of intensity of the infrared light, the image is brighter and has better definition. In addition, when the light-sensitive chip 200 senses single infrared light (the wavelength is λ) emitted by the fill light lamp, because the CF allows the infrared light whose wavelength is λ to transmit, the human eye cannot see an object clearly when only the fill light lamp is present in the evening, but the light-sensitive chip 200 still can sense the infrared light whose wavelength is λ, after the infrared light passes through the red, green and blue filters whose intensity transmittance is 1: (A1/A2): (A1/A3), the intensity sensed by the light-sensitive units corresponding to the red, green and blue filters is 1: (A1/A2): (A1/A3), during processing of the signal processing circuit, the gain ratio of the signal processing circuit to the electric signals correspondingly generated by the light transmitting through the red, green and blue filters is A1: A2: A3, so that the component ratio of red, green and blue colors in the obtained image is 1:1:1; and at this point, the image is a normal black-and-white image.

As a sensitive spectral range of the human eye is visible spectrums of 380 nm to 780 nm, but the human eye cannot perceive spectrums in infrared wavebands, a sensing spectral range of the image sensor is wider than that of the human eye, and a silica-based material may be better sensitive to infrared rays of 940 nm. When visible light and infrared light co-exist in an environment (e.g., in the sun), a situation exists that the color of an image shot by the CMOS image sensor may not be the same as that of the color observed by the human eye. However, in certain applications (e.g., security and protection monitoring applications), it is generally required as follows: when the human eye can clearly observe (e.g., in daytime), the color of an image shot by the CMOS image sensor should be loyal to the human eye; if the human eye cannot clearly observe (e.g., in the evening), the CMOS image sensor can provide a real color or a black-and-white image. Then, M1: M2: M3=1:1:1 can be applied to such applications, especially to security and protection monitoring, but in an environment with both visible light and infrared light, the imaging color may not produce color cast, image brightness and definition are good, and a clear black-and-white image can be shot in the evening, thus meeting application demands.

For another example, if M1: M2: M3=2:1:1, when the light-sensitive chip 200 senses a complicated spectral signal (visible light + infrared light), the intensity sensed by the red light-sensitive unit is greater than that sensed by the other two, the picture may be redish after image processing, the part of visible light will be superimposed thereon, and the component ratio of red, green and blue colors under infrared in the finally obtained image is M1: M2: M3=2:1:1, that is, the color of the finally obtained image deviates from that observed by the human eye, which is wholly redish. When the light-sensitive chip 200 senses single infrared light emitted by the fill light lamp, the image output by the image sensor is also a redish image. The greater the value of M1 is, the redder the color of the finally obtained image is.

For another example, if M1: M2: M3=1:2:1, when the light-sensitive chip 200 senses a complicated spectral signal (visible light + infrared light), the intensity sensed by the green light-sensitive unit is greater than that sensed by the other two, the picture may be greenish after image processing, the part of visible light will be superimposed thereon, and the component ratio of red, green and blue colors under infrared in the finally obtained image is M1: M2: M3=1:2:1, that is, the color of the finally obtained image deviates from that observed by the human eye, which is wholly greenish. When the light-sensitive chip 200 senses single infrared light emitted by the fill light lamp, the image output by the image sensor is also a greenish image. The greater the value of M2 is, the greener the color of the finally obtained image is.

For another example, if M1: M2: M3=1:1:2, when the light-sensitive chip 200 senses a complicated spectral signal (visible light + infrared light), the intensity sensed by the blue light-sensitive unit is greater than that sensed by the other two, the picture may be blueish after image processing, the part of visible light will be superimposed thereon, and the component ratio of red, green and blue colors under infrared in the finally obtained image is M1: M2: M3=1:1:2, that is, the color of the finally obtained image deviates from that observed by the human eye, which is wholly blueish. When the light-sensitive chip 200 senses single infrared light emitted by the fill light lamp, the image output by the image sensor is also a blueish image. The greater the value of M3 is, the bluer the color of the finally obtained image is.

In the above embodiment, a single color cast type is illustrated; however, any color cast type can be selected according to user requirements in other embodiments of the present invention, as long as the ratio of the M value corresponding to each color is adjusted.

For example, if M1: M2: M3=1:1.5:2, when the light-sensitive chip 200 senses a complicated spectral signal (visible light + infrared light), the intensity sensed by the green and blue light-sensitive units is greater than that sensed by the red light-sensitive unit, due to a combination of the green color and the blue color, the picture will be light blueish after image processing, the part of visible light will be superimposed thereon, and the component ratio of red, green and blue colors under infrared in the finally obtained image is M1: M2: M3=1:1.5:2, that is, the color of the finally obtained image deviates from that observed by the human eye, which is wholly light blueish. When the light-sensitive chip 200 senses single infrared light emitted by the fill light lamp, the image output by the image sensor is also a light blueish image.

For another example, if M1: M2: M3= 2:1:1.5, when the light-sensitive chip 200 senses a complicated spectral signal (visible light + infrared light), the intensity sensed by the red and blue light-sensitive units is greater than that sensed by the green light-sensitive unit, due to a combination of the red color and the blue color, the picture will be light purpleish after image processing, the part of visible light will be superimposed thereon, and the component ratio of red, green and blue colors under infrared in the finally obtained image is M1: M2: M3=2:1:1.5, that is, the color of the finally obtained image deviates from that observed by the human eye, which is wholly light purpleish. When the light-sensitive chip 200 senses single infrared light emitted by the fill light lamp, the image output by the image sensor is also a light purpleish image.

It should be noted that the above embodiments are merely schematic descriptions, and those skilled in the art can make corresponding adjustment according to specific demands of the color based on the embodiments of the present invention.

The image sensor according to the embodiment of the present invention can be applied in lots of fields, for example, if it is necessary to shoot a vintage-style picture in a certain application, this can be achieved by setting values of the M1, M2, ..., Mi, ..., Mj, ... and Mn to make the color of the shot picture light brownish, and then the vintage-style picture can be directly shot through the image sensor, thus avoiding problems such as image distortion caused by processing an image into a vintage style through an image processing technology and enhancing user experience.

When the image sensor in the embodiment of the present invention is machined into a product, as different parameters may have lots of product models, generally, the gain ratios of the signal processing circuit corresponding to the image sensor of the same model to the electric signals corresponding to the light transmitting through the multiple n-color filters A1: A2: ...: Ai: ...: Aj: ...: An are the same. In addition, it is possible to adjust the gain ratio of the signal processing circuit to the electric signals according to different scenarios, to achieve restoration of the actual color.

The image sensor according to the embodiment of the present invention achieves user-desired color cast or color cast degree by adjusting optical characteristics of a color filter, thus greatly increasing an application range of the image sensor and enhancing user experience.

In another embodiment of the present invention, as shown in FIG. 6(1), the image sensor 10 further includes: a micro lens 300. The micro lens 300 is located above the color filter 100, and the micro lens 300 is used for receiving and converging the incident light. Specifically, light passes through the micro lens 300, and the micro lens 300 converges and strengthens the light.

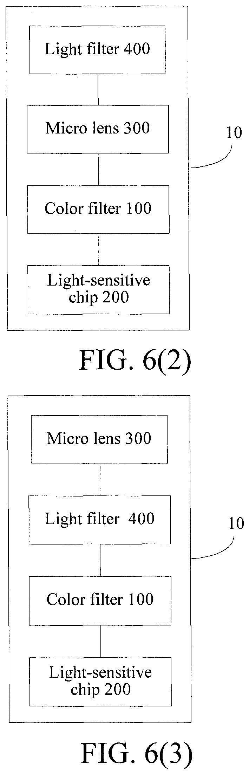

In one embodiment of the present invention, as shown in FIG. 6(2), the image sensor 10 may further include a light filter 400. The light filter 400 is located above the micro lens 300, used for filtering infrared light except the particular-wavelength infrared light, so that a filtering effect is better, and thus the effect of the shot image is also better.

In another embodiment of the present invention, as shown in FIG. 6(3), the light filter 400 may also be directly placed above the color filter 100.

In order to achieve the above embodiment, the present invention further proposes a monitoring system.

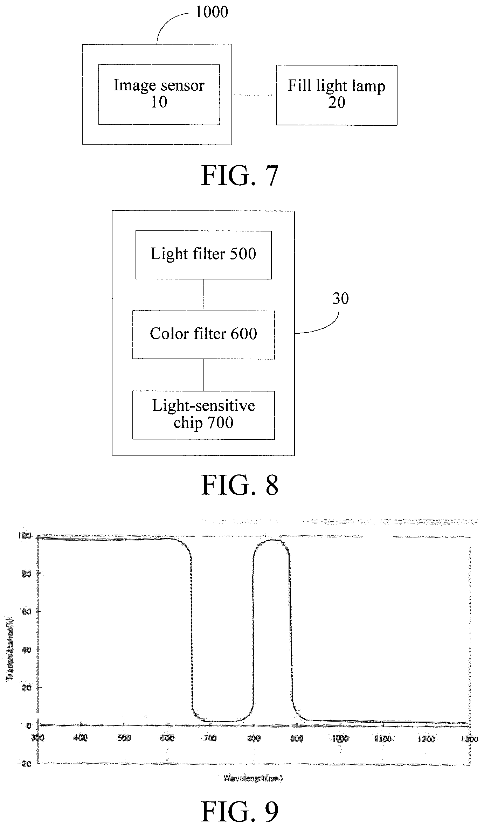

FIG. 7 is a schematic structural diagram of a monitoring system according to one embodiment of the present invention.

As shown in FIG. 7, the monitoring system includes an electronic device 1000 and a fill light lamp 20.

The electronic device 1000 has an image sensor 100, and the fill light lamp 20 emits particular-wavelength infrared light.

The monitoring system according to the embodiment of the present invention can achieve user-desired color cast or color cast degree, thus greatly increasing an application range of the image sensor and enhancing user experience.

FIG. 8 is a schematic structural diagram of an image sensor according to another embodiment of the present invention.

As shown in FIG. 8, the image sensor 30 includes: at least one light filter 500, a color filter 600 and a light-sensitive chip 700.

The light filter 500 is used for filtering infrared light except the particular-wavelength infrared light. The light filter 500 allows visible light and the particular-wavelength infrared light to transmit. The color filter 600 is located below the light filter 500, wherein the color filter 600 includes multiple n-color filters, wherein each filter corresponds to one color, the multiple n-color filters are used for dividing visible light in incident light into n-color light, wherein n is a positive integer. The light-sensitive chip 700 is located below the color filter 600, wherein the light-sensitive chip 700 includes a signal processing circuit and multiple light-sensitive units one-to-one corresponding to the multiple n-color filters, the multiple light-sensitive units are respectively used for sensing intensity of light transmitting through the multiple n-color filters and generating electric signals corresponding to the light transmitting through the multiple n-color filters, the signal processing circuit is used for processing the electric signals for imaging, and a gain ratio of the signal processing circuit to the electric signals is A1: A2: ...: Ai: ...: Aj: ...: An, wherein an intensity transmittance of the multiple n-color filters of the color filter 600 to the particular-wavelength infrared light is M1: M2(A1/A2): ...: Mi(A1/Ai): ...: Mj(A1/Aj): ...: Mn(A1/An), and values of the M1, M2, ..., Mi, ..., Mj, ... and Mn are determined according to color cast required by the image sensor.

Specifically, the light filter 500 is an IR filter, and the light filter 500 is used for filtering infrared light except the particular-wavelength infrared light. That is, the light filter 500 allows visible light and the particular-wavelength infrared light to transmit. For example, the light filter 500 only allows visible light and infrared light whose wavelength is λ (i.e., 850 nm+-50 nm), and light in other wavebands is cut off. FIG. 9 is a schematic diagram of optical characteristics of the light filter 500.

In one embodiment of the present invention, the color cast includes a color cast type. For example, a shot picture is redish, greenish or blueish in color.

In one embodiment of the present invention, the color cast further includes a color cast degree.

In one embodiment of the present invention, the Mi value of a filter corresponding to a target color cast type is greater than the Mj value of other filters.

For ease of description, the image sensor proposed in the present invention is described through examples. Specifically, description is given by taking that n=3 and the color filter 600 includes red, green and blue filters as an example. Herein, it should be noted that, that the color filter 600 includes red, green and blue filters is merely an example made for facilitating description, the color filter 600 may further include filters in other colors, for example, the color filter 600 may include cyan, carmine (or magenta) and yellow filters, and the color filter 600 may include red, green, blue and white filters.

Specifically, after being converged and strengthened by the micro lens, the light reaches the color filter 600 (which can be abbreviated as CF) which has light transmission selectivity (that is, only particular light is allowed to pass) and intensity attenuation (that is, intensity of passing light may decrease). The color filter 600 includes multiple red, green and blue filters used for dividing visible light in incident light into three primary colors, red, green and blue.

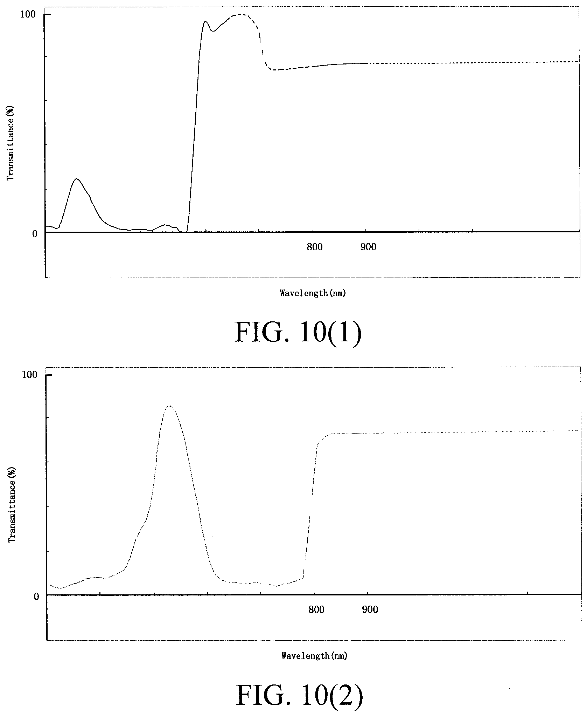

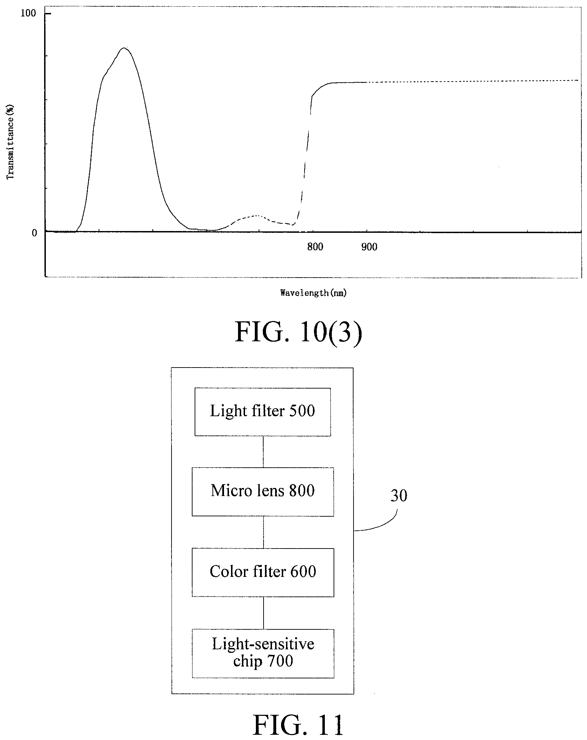

Further, the light-sensitive chip 700 conducts imaging according to light transmitting through the red, green and blue filters of the color filter 600. The red, green and blue filters are arranged in a certain order to form an array. The signal processing circuit processes corresponding electric signals in an order of arrangement of the filters, to restore actual colors and form pictures. More specifically, the light transmitting through the red, green and blue filters of the color filter 600 reaches the underlying light-sensitive unit, the light signals are converted to electric signals, and the electric signals can generate an image after being processed by the signal processing circuit, wherein the light-sensitive units may be photosensitive diodes. More specifically, the optical characteristics of the color filter 600 are adjusted, to cause the intensity transmittance of the multiple red, green and blue filters of the color filter 600 to the particular-wavelength (e.g., 850 nm+-50 nm) infrared light to be M1: M2(A1/A2): M3(A1/A3). As the light filter 500 can filter infrared light except the particular-wavelength infrared light, the intensity transmittance of infrared light in other wavelength ranges does not need to be specially adjusted. FIG. 10(1), FIG. 10(2) and FIG. 10(3) are respectively schematic diagrams of optical characteristics of red, green and blue filters, wherein the dotted line indicates that the value may be arbitrary. Certainly, for ease of convenience, it is possible to adjust the intensity transmittance of all the infrared light as M1: M2(A1/A2): M3(A1/A3); in fact, the infrared light in other wavelength ranges except the particular-wavelength infrared light can be adjusted arbitrarily.

In the embodiment of the present invention, the gain ratio of the signal processing circuit to the electric signals corresponding to the light transmitting through the multiple n-color filters A1: A2: ...: Ai: ...: Aj: ...: An is obtained according to the intensity transmittance of the multiple n-color filters of the color filter to the particular-wavelength infrared light. As required by a picture to be formed, at first, the intensity transmittance of the multiple n-color filters of the color filter to the particular-wavelength infrared light is determined as M1: M2(A1/A2): ...: Mi(A1/Ai): ...: Mj(A1/Aj): ...: Mn(A1/An), wherein values of the M1, M2, ..., Mi, ..., Mj, ... and Mn are determined according to color cast required by the image sensor, next, in a testing process, the gain ratio of the signal processing circuit to the electric signals is determined according to the intensity transmittance of the multiple n-color filters of the color filter to the particular-wavelength infrared light, that is, the gain ratio of the signal processing circuit to the electric signals A1: A2: ...: Ai: ...: Aj: ...: An is obtained through testing.

Specifically, the red, green and blue filters are still taken as an example; in the sun, infrared light is filtered, and only visible light remains; at this point, the red, green and blue light-sensitive units sense intensity of the visible light, which is converted to electric signals and then will be processed by the signal processing circuit, and then an image in a pure color is output; at this point, the gain ratio of the signal processing circuit to the electric signals correspondingly generated by red, green and blue visible light is A1: A2: A3. Certainly, according to requirements, it is known to those skilled in the art that the red, green and blue visible light can be processed, to cause a component ratio of the red, green and blue visible light in the finally obtained image to be 1:1:1, thus obtaining an image whose color is the same as that of an actual object.

In one embodiment of the present invention, in a specific application environment of the image sensor, a fill light lamp can be selected to fill light for the image sensor, and the fill light lamp emits particular-wavelength infrared light.

In the embodiment of the present invention, the particular wavelength matches the wavelength of the infrared light emitted by the selected fill light lamp. That is, the light filter 500 and the selected fill light lamp cooperate for use. Specifically, for example, the wavelength of the infrared light emitted by the fill light lamp is λ, and the light filter 500 allows the infrared light whose wavelength is λ to pass and filter other-wavelength infrared light.

In the embodiment of the present invention, when the light-sensitive chip 700 senses a complicated spectral signal (visible light + infrared light), for the visible light, as the gain ratio of the signal processing circuit to the electric signals correspondingly generated by the light transmitting through the red, green and blue filters is A1: A2: A3, and at the same time, it is known to those skilled in the art that the red, green and blue visible light can be processed, to cause a component ratio of the red, green and blue visible light in the finally obtained image to be 1:1:1, so that the actual visible light color can be restored. For the infrared light, as the intensity transmittance of the multiple red, green and blue filters of the color filter 600 to the particular-wavelength (λ) infrared light is M1: M2(A1/A2): M3(A1/A3), when processed by the signal processing circuit, as the gain ratio of the signal processing circuit to the electric signals correspondingly generated by the light transmitting through the red, green and blue filters is A1: A2: A3, the infrared light is processed by the red, green and blue filters and the light-sensitive chip 700, and then the component ratio of red, green and blue colors under infrared in the obtained image is M1: M2: M3. Therefore, as long as the value of M1: M2: M3 is controlled in advance, color cast and the color cast degree of infrared light imaging can be controlled.

For example, when M1: M2: M3=1:1:1, when the light-sensitive chip 700 senses a complicated spectral signal (visible light + infrared light), for the visible light, as the gain ratio of the signal processing circuit to the electric signals correspondingly generated by the light transmitting through the red, green and blue filters is A1: A2: A3, and at the same time, it is known to those skilled in the art that the red, green and blue visible light can be processed, to cause a component ratio of the red, green and blue visible light in the finally obtained image to be 1:1:1, so that the actual visible light color can be restored. For the infrared light, as the intensity transmittance of the multiple red, green and blue filters of the color filter 600 to the particular-wavelength (λ) infrared light is 1: (A1/A2): (A1/A3), when processed by the signal processing circuit, as the gain ratio of the signal processing circuit to the electric signals correspondingly generated by the light transmitting through the red, green and blue filters is A1: A2: A3, the infrared light is processed by the red, green and blue filters and the light-sensitive chip 700, and then the component ratio of red, green and blue colors under infrared in the obtained image is 1:1:1; the ratio is gray scale of brightness, and thus incidence of the infrared light may not affect the restored color of the visible light. Moreover, due to addition of intensity of the infrared light, the image is brighter and has better definition. In addition, when the light-sensitive chip 700 senses single infrared light (the wavelength is λ) emitted by the fill light lamp, because the color filter 500 allows the infrared light whose wavelength is λ to transmit, the human eye cannot see an object clearly when only the fill light lamp is present in the evening, but the light-sensitive chip 700 still can sense the infrared light whose wavelength is λ, after the infrared light passes through the red, green and blue filters whose intensity transmittance is 1: (A1/A2): (A1/A3), the intensity sensed by the light-sensitive units corresponding to the red, green and blue filters is 1: (A1/A2): (A1/A3), during processing of the signal processing circuit, the gain ratio of the signal processing circuit to the electric signals correspondingly generated by the light transmitting through the red, green and blue filters is A1: A2: A3, so that the component ratio of red, green and blue colors in the obtained image is 1:1:1; and at this point, the image is a normal black-and-white image.

As a sensitive spectral range of the human eye is visible spectrums of 380 nm to 780 nm, but the human eye cannot perceive spectrums in infrared wavebands, a sensing spectral range of the image sensor is wider than that of the human eye, and a silica-based material may be better sensitive to infrared rays of 940 nm. When visible light and infrared light co-exist in an environment (e.g., in the sun), a situation exists that the color of an image shot by the CMOS image sensor may not be the same as that of the color observed by the human eye. However, in certain applications (e.g., security and protection monitoring applications), it is generally required as follows: when the human eye can clearly observe (e.g., in daytime), the color of an image shot by the CMOS image sensor should be loyal to the human eye; if the human eye cannot clearly observe (e.g., in the evening), the CMOS image sensor can provide a real color or a black-and-white image. Then, M1: M2: M3=1:1:1 can be applied to such applications, especially to security and protection monitoring, but in an environment with both visible light and infrared light, imaging color may not produce color cast, image brightness and definition are good, and a clear black-and-white image can be shot in the evening, thus meeting application demands.

For another example, if M1: M2: M3=2:1:1, when the light-sensitive chip 700 senses a complicated spectral signal (visible light + infrared light), the intensity sensed by the red light-sensitive unit is greater than that sensed by the other two, the picture may be redish after image processing, the part of visible light will be superimposed thereon, and the component ratio of red, green and blue colors under infrared in the finally obtained image is M1: M2: M3=2:1:1, that is, the color of the finally obtained image deviates from that observed by the human eye, which is wholly redish. When the light-sensitive chip 700 senses single infrared light emitted by the fill light lamp, the image output by the image sensor is also a redish image. The greater the value of M1 is, the redder the color of the finally obtained image is.

For another example, if M1: M2: M3=1:2:1, when the light-sensitive chip 700 senses a complicated spectral signal (visible light + infrared light), the intensity sensed by the green light-sensitive unit is greater than that sensed by the other two, the picture may be greenish after image processing, the part of visible light will be superimposed thereon, and the component ratio of red, green and blue colors under infrared in the finally obtained image is M1: M2: M3=1:2:1, that is, the color of the finally obtained image deviates from that observed by the human eye, which is wholly greenish. When the light-sensitive chip 700 senses single infrared light emitted by the fill light lamp, the image output by the image sensor is also a greenish image. The greater the value of M2 is, the greener the color of the finally obtained image is.

For another example, if M1: M2: M3=1:1:2, when the light-sensitive chip 700 senses a complicated spectral signal (visible light + infrared light), the intensity sensed by the blue light-sensitive unit is greater than that sensed by the other two, the picture may be blueish after image processing, the part of visible light will be superimposed thereon, and the component ratio of red, green and blue colors under infrared in the finally obtained image is M1: M2: M3=1:1:2, that is, the color of the finally obtained image deviates from that observed by the human eye, which is wholly blueish. When the light-sensitive chip 700 senses single infrared light emitted by the fill light lamp, the image output by the image sensor is also a blueish image. The greater the value of M3 is, the bluer the color of the finally obtained image is.

In the above embodiment, a single color cast type is illustrated; however, any color cast type can be selected according to user requirements in other embodiments of the present invention, as long as the ratio of the M value corresponding to each color is adjusted.

For example, if M1: M2: M3=1:1.5:2, when the light-sensitive chip 700 senses a complicated spectral signal (visible light + infrared light), the intensity sensed by the green and blue light-sensitive units is greater than that sensed by the red light-sensitive unit, due to a combination of the green color and the blue color, the picture will be light blueish after image processing, the part of visible light will be superimposed thereon, and the component ratio of red, green and blue colors under infrared in the finally obtained image is M1: M2: M3=1:1.5:2, that is, the color of the finally obtained image deviates from that observed by the human eye, which is wholly light blueish. When the light-sensitive chip 700 senses single infrared light emitted by the fill light lamp, the image output by the image sensor is also a light blueish image.

For another example, if M1: M2: M3= 2:1:1.5, when the light-sensitive chip 700 senses a complicated spectral signal (visible light + infrared light), the intensity sensed by the red and blue light-sensitive units is greater than that sensed by the green light-sensitive unit, due to a combination of the red color and the blue color, the picture will be light purpleish after image processing, the part of visible light will be superimposed thereon, and the component ratio of red, green and blue colors under infrared in the finally obtained image is M1: M2: M3=2:1:1.5, that is, the color of the finally obtained image deviates from that observed by the human eye, which is wholly light purpleish. When the light-sensitive chip 700 senses single infrared light emitted by the fill light lamp, the image output by the image sensor is also a light purpleish image.

It should be noted that the above embodiments are merely schematic descriptions, and those skilled in the art can make corresponding adjustment according to specific demands of the color based on the embodiments of the present invention.

The image sensor according to the embodiment of the present invention can be applied in lots of fields, for example, if it is necessary to shoot a vintage-style picture in a certain application, this can be achieved by setting values of the M1, M2, ..., Mi, ..., Mj, ... and Mn to make the color of the shot picture light brownish, and then the vintage-style picture can be directly shot through the image sensor, thus avoiding problems such as image distortion caused by processing an image into a vintage style through an image processing technology and enhancing user experience.

When the image sensor in the embodiment of the present invention is machined into a product, as different parameters may have lots of product models, generally, the gain ratios of the signal processing circuit corresponding to the image sensor of the same model to the electric signals corresponding to the light transmitting through the multiple n-color filters A1: A2: ...: Ai: ...: Aj: ...: An are the same. In addition, it is possible to adjust the gain ratio of the signal processing circuit to the electric signals according to different scenarios, to achieve restoration of the actual color.

The image sensor according to the embodiment of the present invention achieves user-desired color cast or color cast degree by adjusting optical characteristics of a color filter, thus greatly increasing an application range of the image sensor and enhancing user experience.

In another embodiment of the present invention, as shown in FIG. 11, the image sensor 30 further includes: a micro lens 800, wherein the micro lens 800 is located between the light filter or light filter assembly 500 and the color filter 600, and the micro lens 800 is used for receiving and converging the incident light. Specifically, light passes through the micro lens 800, and the micro lens 800 converges and strengthens the light.

In order to achieve the above embodiment, the present invention further proposes a monitoring system.

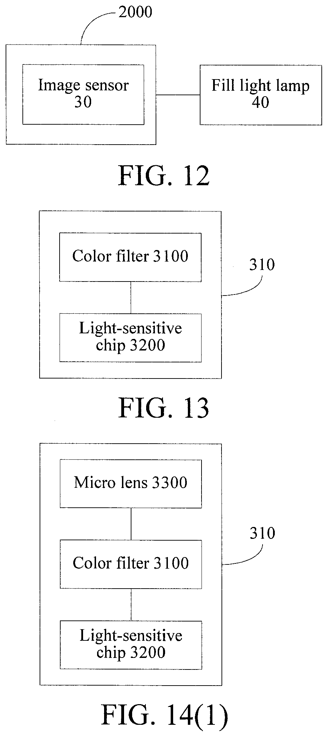

FIG. 12 is a schematic structural diagram of a monitoring system according to one embodiment of the present invention.

As shown in FIG. 12, the monitoring system includes an electronic device 2000 and a fill light lamp 40.

The electronic device 2000 has an image sensor 30, and the fill light lamp 40 emits particular-wavelength infrared light.

The monitoring system according to the embodiment of the present invention can achieve user-desired color cast or color cast degree, thus greatly increasing an application range of the image sensor and enhancing user experience.

FIG. 13 is a schematic structural diagram of a monitoring system according to one embodiment of the present invention. The image sensor according to the embodiment of the present invention is a CMOS image sensor. As shown in FIG. 13, the image sensor 310 includes: a color filter 3100, and a light-sensitive chip 3200.

For visible light, the color filter 3100 allows part of the visible light to transmit; for infrared wavebands, the color filter 3100 only allows particular-wavelength infrared light to pass, an intensity transmittance of the color filter 3100 to the particular-wavelength infrared light is adjustable, and the color filter 3100 includes multiple n-color filters, wherein each filter corresponds to one color, the multiple n-color filters are used for dividing visible light in incident light into n-color light, wherein n is a positive integer. For visible light, the color filter 3100 allows part of the visible light to transmit, which means that the color filter 3100 includes multiple-color filters, for example, when the color filter 3100 includes red, green and blue filters, the red filter only allows red light in the visible light to transmit, the green filter only allows green light in the visible light to transmit, and the blue filter only allows blue light in the visible light to transmit.

The light-sensitive chip 3200 is located below the color filter 3100, the light-sensitive chip 3200 includes a signal processing circuit and multiple light-sensitive units one-to-one corresponding to the multiple n-color filters, the multiple light-sensitive units are respectively used for sensing intensity of light transmitting through the multiple n-color filters and generating electric signals corresponding to the light transmitting through the multiple n-color filters, the signal processing circuit is used for processing the electric signals for imaging, and a gain ratio of the signal processing circuit to the electric signals is M1A1: M2A2: ...: MiAi: ...: MjAj: ...: MnAn, wherein values of the M1, M2, ..., Mi, ..., Mj, ... and Mn are determined according to color cast required by the image sensor, wherein i and j are integers greater than or equal to 1 and less than or equal to n, and i≠j, wherein an intensity transmittance of the multiple n-color filters of the color filter to the particular-wavelength infrared light is 1: (A1/A2): ...: (A1/Ai): ...: (A1/Aj): ...: (A1/An).

In one embodiment of the present invention, the color cast includes a color cast type. For example, a shot picture is redish, greenish or blueish in color.

In one embodiment of the present invention, the color cast further includes a color cast degree.

In one embodiment of the present invention, the Mi value of a filter corresponding to a target color cast type is greater than the Mj value of other filters.

For ease of description, the image sensor proposed in the present invention is described through examples. Specifically, description is given by taking that n=3 and the color filter 3100 includes red, green and blue filters as an example. Herein, it should be noted that, that the color filter 3100 includes red, green and blue filters is merely an example made for facilitating description, the color filter 3100 may further include filters in other colors, for example, the color filter 100 may include cyan, carmine (or magenta) and yellow filters, and the color filter 3100 may include red, green, blue and white filters.

Specifically, after being converged and strengthened by the micro lens, the light reaches the color filter 3100 (which can be abbreviated as CF) which has light transmission selectivity (that is, only particular light is allowed to pass) and intensity attenuation (that is, intensity of passing light may decrease). The color filter 3100 includes multiple red, green and blue filters used for dividing visible light in incident light into three primary colors, red, green and blue, and for infrared light wavebands, the red, green and blue filters only allow particular-wavelength infrared light (e.g., infrared light whose wavelength is 850 nm+-50 nm) to pass. Then, the multiple light-sensitive units are respectively used for sensing intensity of light transmitting through the multiple n-color filters and generating electric signals corresponding to the light transmitting through the multiple n-color filters, and the signal processing circuit is used for processing the electric signals for imaging. The light-sensitive units may be photosensitive diodes.

More specifically, the light-sensitive chip 3200 conducts imaging according to light transmitting through the red, green and blue filters of the color filter 3100. The signal processing circuit processes corresponding electric signals in an order of arrangement of the filters, to restore actual colors and form pictures. More specifically, the light transmitting through the red, green and blue filters of the color filter 3100 passes through the photosensitive diodes, the light signals are converted to electric signals, and the electric signals can generate an image after being processed by the signal processing circuit.

In addition, in the embodiment of the present invention, the gain ratio of the signal processing circuit to the electric signals corresponding to the light transmitting thoruhg the multiple n-color filters M1A1: M2A2: ...: MiAi: ...: MjAj: ...: MnAn is obtained according to the intensity transmittance of the multiple n-color filters of the color filter to the particular-wavelength infrared light, wherein values of the M1, M2, ..., Mi, ..., Mj, ... and Mn are determined according to color cast required by the image sensor. As required by a picture to be formed, at first, the intensity transmittance of the multiple n-color filters of the color filter to the particular-wavelength infrared light is determined as 1: (A1/A2): ...: (A1/Ai): ...: (A1/Aj): ...: (A1/An), next, in a testing process, the gain ratio of the signal processing circuit to the electric signals is determined according to the intensity transmittance of the multiple n-color filters of the color filter to the particular-wavelength infrared light, that is, the gain ratio of the signal processing circuit to the electric signals M1A1: M2A2: ...: MiAi: ...: MjAj: ...: MnAn is obtained through testing.

Specifically, the red, green and blue filters are still taken as an example; in the sun, infrared light is filtered, and only visible light remains; at this point, the red, green and blue light-sensitive units sense intensity of the visible light, which is converted to electric signals and then will be processed by the signal processing circuit, and then an image in a pure color is output; at this point, the gain ratio of the signal processing circuit to the electric signals correspondingly generated by red, green and blue visible light is M1A1: M2A2: M3A3. Certainly, according to requirements, it is known to those skilled in the art that the red, green and blue visible light can be processed, to cause a component ratio of the red, green and blue visible light in the finally obtained image to be 1:1:1, thus obtaining an image whose color is the same as that of an actual object.

In one embodiment of the present invention, in a specific application environment of the image sensor, a fill light lamp can be selected to fill light for the image sensor, and the fill light lamp emits particular-wavelength infrared light.

In the embodiment of the present invention, the particular wavelength matches the wavelength of the infrared light emitted by the selected fill light lamp. Specifically, in a range of infrared wavebands, the color filter 3100 only allows particular-wavelength infrared light to transmit, and other-wavelength infrared light cannot transmit through the color filter 3100.

In the embodiment of the present invention, for example, in the evening, the wavelength of the infrared light emitted by the fill light lamp is λ (e.g., a fill light lamp of 850 nm+-50 nm is used). By adjusting optical characteristics of the CF in advance, only infrared light whose wavelength is λ (850 nm+-50 nm) can pass, while infrared light in other wavebands is cut off. The optical characteristics of the CF are as follows: optical characteristics of visible light wavebands remain unchanged, and in infrared light wavebands, infrared light with an infrared wavelength of λ (850 nm+-50 nm) used by the fill light lamp passes. At the same time, for the infrared light with a wavelength of λ (850 nm+-50 nm), the intensity transmittance of the multiple red, green and blue filters of the color filter 3100 to the particular-wavelength (λ) infrared light is 1: (A1/A2): (A1/A3).

Specifically, when the light-sensitive chip 3200 senses a complicated spectral signal (visible light + infrared light), for the visible light, as the gain ratio of the signal processing circuit to the electric signals corresponding to the light transmitting through the red, green and blue filters is M1A1: M2A2: M3A3, and at the same time, it is known to those skilled in the art that the red, green and blue visible light can be processed, to cause a component ratio of the red, green and blue visible light in the finally obtained image to be 1:1:1, so that the actual visible light color can be restored. For the infrared light, as the intensity transmittance of the multiple red, green and blue filters of the color filter 3100 to the particular-wavelength (λ) infrared light is 1: (A1/A2): (A1/A3), when processed by the signal processing circuit, as the gain ratio of the signal processing circuit to the electric signals correspondingly generated by the light transmitting through the red, green and blue filters is M1A1: M2A2: M3A3, the infrared light is processed by the red, green and blue filters and the light-sensitive chip 200, and then the component ratio of red, green and blue colors under infrared in the obtained image is M1: M2: M3. Therefore, as long as the value of M1: M2: M3 is controlled in advance, color cast and the color cast degree of infrared light imaging can be controlled.

For example, when M1: M2: M3=1:1:1, when the light-sensitive chip 3200 senses a complicated spectral signal (visible light + infrared light), for the visible light, as the gain ratio of the signal processing circuit to the electric signals correspondingly generated by the light transmitting through the red, green and blue filters is A1: A2: A3, and at the same time, it is known to those skilled in the art that the red, green and blue visible light can be processed, to cause a component ratio of the red, green and blue visible light in the finally obtained image to be 1:1:1, so that the actual visible light color can be restored. For the infrared light, as the intensity transmittance of the multiple red, green and blue filters of the color filter 3100 to the particular-wavelength (λ) infrared light is 1: (A1/A2): (A1/A3), when processed by the signal processing circuit, as the gain ratio of the signal processing circuit to the electric signals correspondingly generated by the light transmitting through the red, green and blue filters is A1: A2: A3, the infrared light is processed by the red, green and blue filters and the light-sensitive chip 3200, and then the component ratio of red, green and blue colors under infrared in the obtained image is 1:1:1; the ratio is gray scale of brightness, and thus incidence of the infrared light may not affect the restored color of the visible light. Moreover, due to addition of intensity of the infrared light, the image is brighter and has better definition. In addition, when the light-sensitive chip 3200 senses single infrared light (the wavelength is λ) emitted by the fill light lamp, because the CF allows the infrared light whose wavelength is λ to transmit, the human eye cannot see an object clearly when only the fill light lamp is present in the evening, but the light-sensitive chip 3200 still can sense the infrared light whose wavelength is λ, after the infrared light passes through the red, green and blue filters whose intensity transmittance is 1: (A1/A2): (A1/A3), the intensity sensed by the light-sensitive units corresponding to the red, green and blue filters is 1: (A1/A2): (A1/A3), during processing of the signal processing circuit, the gain ratio of the signal processing circuit to the electric signals correspondingly generated by the light transmitting through the red, green and blue filters is A1: A2: A3, so that the component ratio of red, green and blue colors in the obtained image is 1:1:1; and at this point, the image is a normal black-and-white image.

As a sensitive spectral range of the human eye is visible spectrums of 380 nm to 780 nm, but the human eye cannot perceive spectrums in infrared wavebands, a sensing spectral range of the image sensor is wider than that of the human eye, and a silica-based material may be better sensitive to infrared rays of 940 nm. When visible light and infrared light co-exist in an environment (e.g., in the sun), a situation exists that the color of an image shot by the CMOS image sensor may not be the same as that of the color observed by the human eye. However, in certain applications (e.g., security and protection monitoring applications), it is generally required as follows: when the human eye can clearly observe (e.g., in daytime), the color of an image shot by the CMOS image sensor should be loyal to the human eye; if the human eye cannot clearly observe (e.g., in the evening), the CMOS image sensor can provide a real color or a black-and-white image. Then, M1: M2: M3=1:1:1 can be applied to such applications, especially to security and protection monitoring, but in an environment with both visible light and infrared light, imaging color may not produce color cast, image brightness and definition are good, and a clear black-and-white image can be shot in the evening, thus meeting application demands.

For another example, if M1: M2: M3=2:1:1, when the light-sensitive chip 3200 senses a complicated spectral signal (visible light + infrared light), the intensity sensed by the red light-sensitive unit is greater than that sensed by the other two, the picture may be redish after image processing, the part of visible light will be superimposed thereon, and the component ratio of red, green and blue colors under infrared in the finally obtained image is M1: M2: M3=2:1:1, that is, the color of the finally obtained image deviates from that observed by the human eye, which is wholly redish. When the light-sensitive chip 3200 senses single infrared light emitted by the fill light lamp, the image output by the image sensor is also a redish image. The greater the value of M1 is, the redder the color of the finally obtained image is.

For another example, if M1: M2: M3=1:2:1, when the light-sensitive chip 3200 senses a complicated spectral signal (visible light + infrared light), the intensity sensed by the green light-sensitive unit is greater than that sensed by the other two, the picture may be greenish after image processing, the part of visible light will be superimposed thereon, and the component ratio of red, green and blue colors under infrared in the finally obtained image is M1: M2: M3=1:2:1, that is, the color of the finally obtained image deviates from that observed by the human eye, which is wholly greenish. When the light-sensitive chip 3200 senses single infrared light emitted by the fill light lamp, the image output by the image sensor is also a greenish image. The greater the value of M2 is, the greener the color of the finally obtained image is.

For another example, if M1: M2: M3=1:1:2, when the light-sensitive chip 3200 senses a complicated spectral signal (visible light + infrared light), the intensity sensed by the blue light-sensitive unit is greater than that sensed by the other two, the picture may be blueish after image processing, the part of visible light will be superimposed thereon, and the component ratio of red, green and blue colors under infrared in the finally obtained image is M1: M2: M3=1:1:2, that is, the color of the finally obtained image deviates from that observed by the human eye, which is wholly blueish. When the light-sensitive chip 3200 senses single infrared light emitted by the fill light lamp, the image output by the image sensor is also a blueish image. The greater the value of M3 is, the bluer the color of the finally obtained image is.

In the above embodiment, a single color cast type is illustrated; however, any color cast type can be selected according to user requirements in other embodiments of the present invention, as long as the ratio of the M value corresponding to each color is adjusted.

For example, if M1: M2: M3=1:1.5:2, when the light-sensitive chip 3200 senses a complicated spectral signal (visible light + infrared light), the intensity sensed by the green and blue light-sensitive units is greater than that sensed by the red light-sensitive unit, due to a combination of the green color and the blue color, the picture will be light blueish after image processing, the part of visible light will be superimposed thereon, and the component ratio of red, green and blue colors under infrared in the finally obtained image is M1: M2: M3=1:1.5:2, that is, the color of the finally obtained image deviates from that observed by the human eye, which is wholly light blueish. When the light-sensitive chip 3200 senses single infrared light emitted by the fill light lamp, the image output by the image sensor is also a light blueish image.

For another example, if M1: M2: M3= 2:1:1.5, when the light-sensitive chip 3200 senses a complicated spectral signal (visible light + infrared light), the intensity sensed by the red and blue light-sensitive units is greater than that sensed by the green light-sensitive unit, due to a combination of the red color and the blue color, the picture will be light purpleish after image processing, the part of visible light will be superimposed thereon, and the component ratio of red, green and blue colors under infrared in the finally obtained image is M1: M2: M3=2:1:1.5, that is, the color of the finally obtained image deviates from that observed by the human eye, which is wholly light purpleish. When the light-sensitive chip 3200 senses single infrared light emitted by the fill light lamp, the image output by the image sensor is also a light purpleish image.

It should be noted that the above embodiments are merely schematic descriptions, and those skilled in the art can make corresponding adjustment according to specific demands of the color based on the embodiments of the present invention.

The image sensor according to the embodiment of the present invention can be applied in lots of fields, for example, if it is necessary to shoot a vintage-style picture in a certain application, this can be achieved by setting values of the M1, M2, ..., Mi, ..., Mj, ... and Mn to make the color of the shot picture light brownish, and then the vintage-style picture can be directly shot through the image sensor, thus avoiding problems such as image distortion caused by processing an image into a vintage style through an image processing technology and enhancing user experience.

When the image sensor in the embodiment of the present invention is machined into a product, as different parameters may have lots of product models, generally, the gain ratio of the signal processing circuit corresponding to the image sensor of the same model to the electric signals corresponding to the light transmitting through the multiple n-color filters M1A1: M2A2: ...: MiAi: ...: MjAj: ...: MnAn is the same. In addition, it is possible to adjust the gain ratio of the signal processing circuit to the electric signals according to different scenarios, to achieve restoration of the actual color.

The image sensor according to the embodiment of the present invention achieves user-desired color cast or color cast degree by adjusting optical characteristics of a color filter, thus greatly increasing an application range of the image sensor and enhancing user experience.

In another embodiment of the present invention, as shown in FIG. 14(1), the image sensor 310 further includes: a micro lens 3300. The micro lens 3300 is located above the color filter 3100, and the micro lens 3300 is used for receiving and converging the incident light. Specifically, light passes through the micro lens 3300, and the micro lens 3300 converges and strengthens the light.

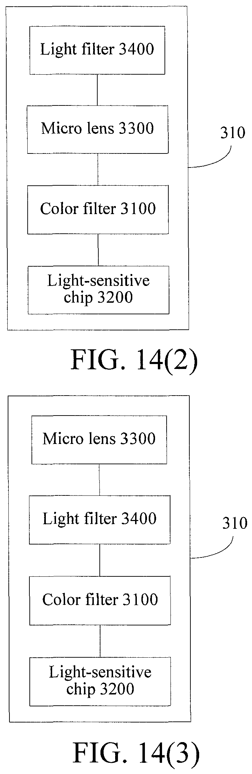

In one embodiment of the present invention, as shown in FIG. 14(2), the image sensor 310 may further include a light filter 3400. The light filter 3400 is located above the micro lens 3300, used for filtering infrared light except the particular-wavelength infrared light, so that a filtering effect is better, and thus the effect of the shot image is also better.

In another embodiment of the present invention, as shown in FIG. 14(3), the light filter 3400 may also be directly placed above the color filter 3100.

In order to achieve the above embodiment, the present invention further proposes a monitoring system.

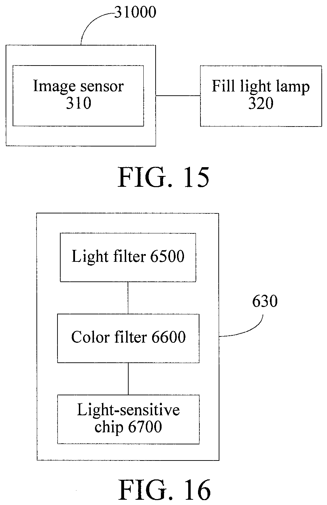

FIG. 15 is a schematic structural diagram of a monitoring system according to one embodiment of the present invention.

As shown in FIG. 15, the monitoring system includes an electronic device 31000 and a fill light lamp 320.

The electronic device 31000 has an image sensor 310, and the fill light lamp 320 emits particular-wavelength infrared light.

The monitoring system according to the embodiment of the present invention can achieve user-desired color cast or color cast degree, thus greatly increasing an application range of the image sensor and enhancing user experience.

FIG. 16 is a schematic structural diagram of an image sensor according to another embodiment of the present invention.

As shown in FIG. 16, the image sensor 630 includes: at least one light filter 6500, a color filter 6600 and a light-sensitive chip 6700.

The light filter 6500 is used for filtering infrared light except the particular-wavelength infrared light. The light filter 6500 allows visible light and the particular-wavelength infrared light to transmit. The color filter 6600 is located below the light filter 6500, wherein the color filter 6600 includes multiple n-color filters, wherein each filter corresponds to one color, the multiple n-color filters are used for dividing visible light in incident light into n-color light, wherein n is a positive integer. The light-sensitive chip 6700 is located below the color filter 6600, wherein the light-sensitive chip 6700 includes a signal processing circuit and multiple light-sensitive units one-to-one corresponding to the multiple n-color filters, the multiple light-sensitive units are respectively used for sensing intensity of light transmitting through the multiple n-color filters and generating electric signals corresponding to the light transmitting through the multiple n-color filters, the signal processing circuit is used for processing the electric signals for imaging, and a gain ratio of the signal processing circuit to the electric signals is M1A1: M2A2: ...: MiAi: ...: MjAj: ...: MnAn, wherein values of the M1, M2, ..., Mi, ..., Mj, ... and Mn are determined according to color cast required by the image sensor, wherein i and j are integers greater than or equal to 1 and less than or equal to n, and i≠j, wherein an intensity transmittance of the multiple n-color filters of the color filter 6600 to the particular-wavelength infrared light is 1: (A1/A2): ...: (A1/Ai): ...: (A1/Aj): ...: (A1/An).

Specifically, the light filter 6500 is an IR filter, and the light filter 6500 is used for filtering infrared light except the particular-wavelength infrared light. That is, the light filter 6500 allows visible light and the particular-wavelength infrared light to transmit. For example, the light filter 6500 only allows visible light and infrared light whose wavelength is λ (i.e., 850 nm+-50 nm), and light in other wavebands is cut off.

In one embodiment of the present invention, the color cast includes a color cast type. For example, a shot picture is redish, greenish or blueish in color.

In one embodiment of the present invention, the color cast further includes a color cast degree.

In one embodiment of the present invention, the Mi value of a filter corresponding to a target color cast type is greater than the Mj value of other filters.

For ease of description, the image sensor proposed in the present invention is described through examples. Specifically, description is given by taking that n=3 and the color filter 6600 includes red, green and blue filters as an example. Herein, it should be noted that, that the color filter 6600 includes red, green and blue filters is merely an example made for facilitating description, the color filter 6600 may further include filters in other colors, for example, the color filter 6600 may include cyan, carmine (or magenta) and yellow filters, and the color filter 6600 may include red, green, blue and white filters.

Specifically, after being converged and strengthened by the micro lens, the light reaches the color filter 6600 (which can be abbreviated as CF) which has light transmission selectivity (that is, only particular light is allowed to pass) and intensity attenuation (that is, intensity of passing light may decrease). The color filter 6600 includes multiple red, green and blue filters used for dividing visible light in incident light into three primary colors, red, green and blue.

Further, the light-sensitive chip 6700 conducts imaging according to light transmitting through the red, green and blue filters of the color filter 6600. The red, green and blue filters are arranged in a certain order to form an array. The signal processing circuit processes corresponding electric signals in an order of arrangement of the filters, to restore actual colors and form pictures. More specifically, the light transmitting through the red, green and blue filters of the color filter 6600 reaches the underlying light-sensitive unit, the light signals are converted to electric signals, and the electric signals can generate an image after being processed by the signal processing circuit, wherein the light-sensitive units may be photosensitive diodes. More specifically, the optical characteristics of the color filter 6600 are adjusted, to cause the intensity transmittance of the multiple red, green and blue filters of the color filter 6600 to the particular-wavelength (e.g., 850 nm+-50 nm) infrared light to be 1: (A1/A2): (A1/A3). As the light filter 6500 can filter infrared light except the particular-wavelength infrared light, the intensity transmittance of infrared light in other wavelength ranges does not need to be specially adjusted. Certainly, for ease of convenience, it is possible to adjust the intensity transmittance of all the infrared light as 1: (A1/A2): (A1/A3); in fact, the infrared light in other wavelength ranges except the particular-wavelength infrared light can be adjusted arbitrarily.

In the embodiment of the present invention, the gain ratio of the signal processing circuit to the electric signals corresponding to the light transmitting through the multiple n-color filters M1A1: M2A2: ...: MiAi: ...: MjAj: ...: MnAn is obtained according to the intensity transmittance of the multiple n-color filters of the color filter to the particular-wavelength infrared light. As required by a picture to be formed, at first, the intensity transmittance of the multiple n-color filters of the color filter to the particular-wavelength infrared light is determined as 1: (A1/A2): .... (A1/Ai): ...: (A1/Aj): ...: (A1/An), next, in a testing process, the gain ratio of the signal processing circuit to the electric signals is determined according to the intensity transmittance of the multiple n-color filters of the color filter to the particular-wavelength infrared light, that is, the gain ratio of the signal processing circuit to the electric signals M1A1: M2A2: ...: MiAi: ...: MjAj: ...: MnAn is obtained through testing.

Specifically, the red, green and blue filters are still taken as an example; in the sun, infrared light is filtered, and only visible light remains; at this point, the red, green and blue light-sensitive units sense intensity of the visible light, which is converted to electric signals and then will be processed by the signal processing circuit, and then an image in a pure color is output; at this point, the gain ratio of the signal processing circuit to the electric signals correspondingly generated by red, green and blue visible light is M1A1: M2A2: M3A3. Certainly, according to requirements, it is known to those skilled in the art that the red, green and blue visible light can be processed, to cause a component ratio of the red, green and blue visible light in the finally obtained image to be 1:1:1, thus obtaining an image whose color is the same as that of an actual object.

In one embodiment of the present invention, in a specific application environment of the image sensor, a fill light lamp can be selected to fill light for the image sensor, and the fill light lamp emits particular-wavelength infrared light.

In the embodiment of the present invention, the particular wavelength matches the wavelength of the infrared light emitted by the selected fill light lamp. That is, the light filter 6500 and the selected fill light lamp cooperate for use. Specifically, for example, the wavelength of the infrared light emitted by the fill light lamp is λ, and at least one light filter 6500 allows the infrared light whose wavelength is λ to pass and filter other-wavelength infrared light.

In the embodiment of the present invention, when the light-sensitive chip 6700 senses a complicated spectral signal (visible light + infrared light), for the visible light, as the gain ratio of the signal processing circuit to the electric signals corresponding to the light transmitting through the red, green and blue filters is M1A1: M2A2: M3A3, and at the same time, it is known to those skilled in the art that the red, green and blue visible light can be processed, to cause a component ratio of the red, green and blue visible light in the finally obtained image to be 1:1:1, so that the actual visible light color can be restored. For the infrared light, as the intensity transmittance of the multiple red, green and blue filters of the color filter 6600 to the particular-wavelength (λ) infrared light is 1: (A1/A2): (A1/A3), when processed by the signal processing circuit, as the gain ratio of the signal processing circuit to the electric signals correspondingly generated by the light transmitting through the red, green and blue filters is M1A1: M2A2: M3A3, the infrared light is processed by the red, green and blue filters and the light-sensitive chip 6700, and then the component ratio of red, green and blue colors under infrared in the obtained image is M1: M2: M3. Therefore, as long as the value of M1: M2: M3 is controlled in advance, color cast and the color cast degree of infrared light imaging can be controlled.

For example, when M1: M2: M3=1:1:1, when the light-sensitive chip 6700 senses a complicated spectral signal (visible light + infrared light), for the visible light, as the gain ratio of the signal processing circuit to the electric signals correspondingly generated by the light transmitting through the red, green and blue filters is A1: A2: A3, and at the same time, it is known to those skilled in the art that the red, green and blue visible light can be processed, to cause a component ratio of the red, green and blue visible light in the finally obtained image to be 1:1:1, so that the actual visible light color can be restored. For the infrared light, as the intensity transmittance of the multiple red, green and blue filters of the color filter 6600 to the particular-wavelength (λ) infrared light is 1: (A1/A2): (A1/A3), when processed by the signal processing circuit, as the gain ratio of the signal processing circuit to the electric signals correspondingly generated by the light transmitting through the red, green and blue filters is A1: A2: A3, the infrared light is processed by the red, green and blue filters and the light-sensitive chip 6700, and then the component ratio of red, green and blue colors under infrared in the obtained image is 1:1:1; the ratio is gray scale of brightness, and thus incidence of the infrared light may not affect the restored color of the visible light. Moreover, due to addition of intensity of the infrared light, the image is brighter and has better definition. In addition, when the light-sensitive chip 6700 senses single infrared light (the wavelength is λ) emitted by the fill light lamp, because the color filter 6500 allows the infrared light whose wavelength is λ to transmit, the human eye cannot see an object clearly when only the fill light lamp is present in the evening, but the light-sensitive chip 6700 still can sense the infrared light whose wavelength is λ, after the infrared light passes through the red, green and blue filters whose intensity transmittance is 1: (A1/A2): (A1/A3), the intensity sensed by the light-sensitive units corresponding to the red, green and blue filters is 1: (A1/A2): (A1/A3), during processing of the signal processing circuit, the gain ratio of the signal processing circuit to the electric signals correspondingly generated by the light transmitting through the red, green and blue filters is A1: A2: A3, so that the component ratio of red, green and blue colors in the obtained image is 1:1:1; and at this point, the image is a normal black-and-white image.

As a sensitive spectral range of the human eye is visible spectrums of 380 nm to 780 nm, but the human eye cannot perceive spectrums in infrared wavebands, a sensing spectral range of the image sensor is wider than that of the human eye, and a silica-based material may be better sensitive to infrared rays of 940 nm. When visible light and infrared light co-exist in an environment (e.g., in the sun), a situation exists that the color of an image shot by the CMOS image sensor may not be the same as that of the color observed by the human eye. However, in certain applications (e.g., security and protection monitoring applications), it is generally required as follows: when the human eye can clearly observe (e.g., in daytime), the color of an image shot by the CMOS image sensor should be loyal to the human eye; if the human eye cannot clearly observe (e.g., in the evening), the CMOS image sensor can provide a real color or a black-and-white image. Then, M1: M2: M3=1:1:1 can be applied to such applications, especially to security and protection monitoring, but in an environment with both visible light and infrared light, imaging color may not produce color cast, image brightness and definition are good, and a clear black-and-white image can be shot in the evening, thus meeting application demands.

For another example, if M1: M2: M3=2:1:1, when the light-sensitive chip 6700 senses a complicated spectral signal (visible light + infrared light), the intensity sensed by the red light-sensitive unit is greater than that sensed by the other two, the picture may be redish after image processing, the part of visible light will be superimposed thereon, and the component ratio of red, green and blue colors under infrared in the finally obtained image is M1: M2: M3=2:1:1, that is, the color of the finally obtained image deviates from that observed by the human eye, which is wholly redish. When the light-sensitive chip 6700 senses single infrared light emitted by the fill light lamp, the image output by the image sensor is also a redish image. The greater the value of M1 is, the redder the color of the finally obtained image is.

For another example, if M1: M2: M3=1:2:1, when the light-sensitive chip 6700 senses a complicated spectral signal (visible light + infrared light), the intensity sensed by the green light-sensitive unit is greater than that sensed by the other two, the picture may be greenish after image processing, the part of visible light will be superimposed thereon, and the component ratio of red, green and blue colors under infrared in the finally obtained image is M1: M2: M3=1:2:1, that is, the color of the finally obtained image deviates from that observed by the human eye, which is wholly greenish. When the light-sensitive chip 6700 senses single infrared light emitted by the fill light lamp, the image output by the image sensor is also a greenish image. The greater the value of M2 is, the greener the color of the finally obtained image is.

For another example, if M1: M2: M3=1:1:2, when the light-sensitive chip 6700 senses a complicated spectral signal (visible light + infrared light), the intensity sensed by the blue light-sensitive unit is greater than that sensed by the other two, the picture may be blueish after image processing, the part of visible light will be superimposed thereon, and the component ratio of red, green and blue colors under infrared in the finally obtained image is M1: M2: M3=1:1:2, that is, the color of the finally obtained image deviates from that observed by the human eye, which is wholly blueish. When the light-sensitive chip 6700 senses single infrared light emitted by the fill light lamp, the image output by the image sensor is also a blueish image. The greater the value of M3 is, the bluer the color of the finally obtained image is.

In the above embodiment, a single color cast type is illustrated; however, any color cast type can be selected according to user requirements in other embodiments of the present invention, as long as the ratio of the M value corresponding to each color is adjusted.

For example, if M1: M2: M3=1:1.5:2, when the light-sensitive chip 6700 senses a complicated spectral signal (visible light + infrared light), the intensity sensed by the green and blue light-sensitive units is greater than that sensed by the red light-sensitive unit, due to a combination of the green color and the blue color, the picture will be light blueish after image processing, the part of visible light will be superimposed thereon, and the component ratio of red, green and blue colors under infrared in the finally obtained image is M1: M2: M3=1:1.5:2, that is, the color of the finally obtained image deviates from that observed by the human eye, which is wholly light blueish. When the light-sensitive chip 6700 senses single infrared light emitted by the fill light lamp, the image output by the image sensor is also a light blueish image.

For another example, if M1: M2: M3= 2:1:1.5, when the light-sensitive chip 6700 senses a complicated spectral signal (visible light + infrared light), the intensity sensed by the red and blue light-sensitive units is greater than that sensed by the green light-sensitive unit, due to a combination of the red color and the blue color, the picture will be light purpleish after image processing, the part of visible light will be superimposed thereon, and the component ratio of red, green and blue colors under infrared in the finally obtained image is M1: M2: M3=2:1:1.5, that is, the color of the finally obtained image deviates from that observed by the human eye, which is wholly light purpleish. When the light-sensitive chip 6700 senses single infrared light emitted by the fill light lamp, the image output by the image sensor is also a light purpleish image.

It should be noted that the above embodiments are merely schematic descriptions, and those skilled in the art can make corresponding adjustment according to specific demands of the color based on the embodiments of the present invention.

The image sensor according to the embodiment of the present invention can be applied in lots of fields, for example, if it is necessary to shoot a vintage-style picture in a certain application, this can be achieved by setting values of the M1, M2, ..., Mi, ..., Mj, ... and Mn to make the color of the shot picture light brownish, and then the vintage-style picture can be directly shot through the image sensor, thus avoiding problems such as image distortion caused by processing an image into a vintage style through an image processing technology and enhancing user experience.

When the image sensor in the embodiment of the present invention is machined into a product, as different parameters may have lots of product models, generally, the gain ratios of the signal processing circuit corresponding to the image sensor of the same model to the electric signals corresponding to the light transmitting through the multiple n-color filters M1A1: M2A2: ...: MiAi: ...: MjAj: ...: MnAn are the same. In addition, it is possible to adjust the gain ratio of the signal processing circuit to the electric signals according to different scenarios, to achieve restoration of the actual color.

The image sensor according to the embodiment of the present invention achieves user-desired color cast or color cast degree by adjusting optical characteristics of a color filter and using a light filter having particular optical characteristics, thus greatly increasing an application range of the image sensor and enhancing user experience.

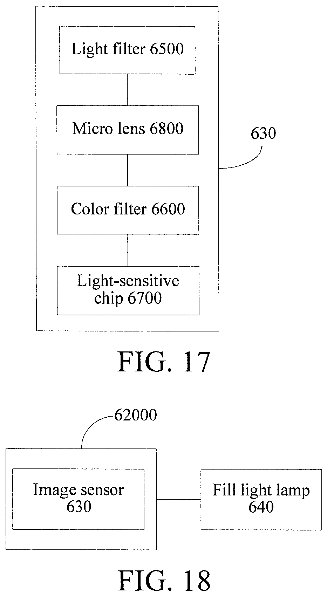

In another embodiment of the present invention, as shown in FIG. 17, the image sensor 630 further includes: a micro lens 6800, wherein the micro lens 6800 is located between the light filter or light filter assembly 6500 and the color filter 6600, and the micro lens 6800 is used for receiving and converging the incident light. Specifically, light passes through the micro lens 6800, and the micro lens 6800 converges and strengthens the light.

In order to achieve the above embodiment, the present invention further proposes a monitoring system.

FIG. 18 is a schematic structural diagram of a monitoring system according to one embodiment of the present invention.

As shown in FIG. 18, the monitoring system includes an electronic device 62000 and a fill light lamp 640.

The electronic device 62000 has an image sensor 630, and the fill light lamp 640 emits particular-wavelength infrared light.

The monitoring system according to the embodiment of the present invention can achieve user-desired color cast or color cast degree, thus greatly increasing an application range of the image sensor and enhancing user experience.

It should be noted that the above embodiments are merely schematic descriptions, and those skilled in the art can make corresponding adjustment according to specific demands of the color based on the embodiments of the present invention.

A method for designing an image sensor according to an embodiment of the present invention can control influences of infrared light on the imaging color according to requirements of actual applications, thus greatly increasing the application range of the image sensor.

To achieve the above embodiment, the present invention further proposes an image sensor. The image sensor is an image sensor formed with the method for designing an image sensor according to the embodiment of the present invention.

The image sensor according to the embodiment of the present invention can design influences of infrared light on the imaging color according to requirements of actual applications, thus greatly increasing the application range of the image sensor.

In the description of the present invention, it should be understood that direction or position relationships indicated by the terms "center", "longitudinal", "transverse", "length", "width", "thickness", "up", "down", "front", "back", "left", "right", "vertical", "horizontal", "top", "bottom", "inner", "outer", "clockwise", "counterclockwise", "axial", "radial", "circumferential" and the like are direction or position relationships shown based on the accompanying drawings, which are merely intended to make it easy to describe the present invention and simplify the description, instead of indicating or implying that the apparatus or element indicated has to have a particular direction and to be constructed or operated with the particular direction, and thus cannot be constructed as limitations to the present invention.

In addition, the terms "first" and "second" are only used for description but cannot be understood as indicating or implying relative importance or implicitly indicating the number of the indicated technical feature. Thus, the features defined with "first" and "second" can explicitly or implicitly include at least one of the features. In the description of the present invention, the meaning of "multiple" is at least two, for example, two, three or the like, unless otherwise definitely and specifically defined.

In the present invention, unless otherwise explicitly stipulated and defined, the terms "install", "connected with", "connect" and "fix" should be understood in a broad sense, for example, it may be a fixed connection, a detachable connection or an integral connection; may be a mechanical connection or an electrical connection; may be a direct connection or a connection through an intermediate medium, and may be communication inside two elements or an interaction relationship of two elements, unless otherwise explicitly defined. For those of ordinary skill in the art, the specific meanings of the terms in the present invention can be understood according to specific situations.

In the present invention, unless otherwise explicitly stipulated and defined, the first feature being "up" or "down" the second feature may be that the first and second features are in direct contact, or the first and second features are in direct contact through an intermediate medium. Moreover, the first feature being "above", "over" and "on" the second feature may be that the first feature is directly over or obliquely over the second feature, or merely indicates that the level height of the first feature is higher than that of the second feature. The first feature being "below", "beneath" and "under" the second feature may be that the first feature is directly beneath or obliquely beneath the second feature, or merely indicates that the level height of the first feature is less than that of the second feature.

In the description of the specification, the description of reference terms "one embodiment", "some embodiments", "example", "specific example" or "some examples" and the like means that specific features, structures, materials or features described in combination with the embodiment(s) or example(s) are included in at least one embodiment or example of the present invention. In the specification, schematic expression of the above terms may not necessarily refer to the same embodiment or example. Moreover, the described specific features, structures, materials or features may be combined in an appropriate manner in any one or more embodiments or examples. In addition, in a situation of not being mutually contradictory, those skilled in the art can unite and combine different embodiments or examples and features of the different embodiments or examples described in the specification.

Although the embodiments of the present invention have been illustrated and described above, it would be appreciated that the above embodiments are exemplary and cannot be construed as limiting the present invention. Those of ordinary skill in the art can make changes, modifications, replacements and variations to the above embodiments within the scope of the present invention.

## Claims

1. An image sensor, comprising:
a color filter, wherein, for light in infrared wavebands, the color filter is arranged to allow a particular-wavelength infrared light to pass, and the color filter comprises multiple n-color filters, wherein each of the multiple n-color filters corresponds to a color, the multiple n-color filters are arranged to divide visible light in incident light into n-color light, wherein n is a positive integer; and
a light-sensitive chip located below the color filter, wherein the light-sensitive chip comprises a signal processing circuit and multiple light-sensitive units one-to-one corresponding to the multiple n-color filters, the multiple light-sensitive units are respectively arranged to sense intensity of light transmitting through the multiple n-color filters and generate electric signals corresponding to the light transmitting through the multiple n-color filters, the signal processing circuit is configured to process the electric signals for imaging, wherein a gain ratio of the signal processing circuit to the electric signals is A1: A2: ...: Ai: ...: Aj: ...: An, wherein i and j are integers greater than or equal to 1 and less than or equal to n, and i≠j,
wherein an intensity transmittance of the multiple n-color filters of the color filter to the particular-wavelength infrared light is M1: M2(A1/A2): ...: Mi(A1/Ai): ...: Mj(A1/Aj): ...: Mn(A1/An), and values of the M1, M2, ..., Mi, ..., Mj, ... and Mn are determined according to color cast required by the image sensor.

2. The image sensor according to claim 1, further comprising:
a micro lens located above the color filter, wherein the micro lens is arranged to receive and converge the incident light.

3. The image sensor according to claim 1 or 2, wherein the color cast comprises a color cast type.

4. The image sensor according to claim 3, wherein the color cast further comprises a color cast degree.

5. The image sensor according to claim 3 or 4, wherein the Mi value of a filter corresponding to a target color cast type is greater than the Mj value of other filters.

6. The image sensor according to any one of claims 1 to 5, wherein the gain ratio of the signal processing circuit to the electric signals A1: A2: ...: Ai: ...: Aj: ...: An is obtained according to the intensity transmittance of the multiple n-color filters of the color filter to the particular-wavelength infrared light.

7. The image sensor according to claim 2, further comprising:
a light filter located above the micro lens, and arranged to filter the particular-wavelength infrared light, such that the particular wavelength infrared light passes through the filter.

8. The image sensor according to any one of claims 1 to 6, further comprising:
a light filter located above the color filter, and arranged to filter the particular-wavelength infrared light, such that the particular wavelength infrared light passes through the filter.

9. A monitoring system, comprising:
an electronic device, wherein the electronic device comprises the image sensor according to any one of claims 1 to 8; and
a fill light lamp, wherein the fill light lamp emits the particular-wavelength infrared light.

10. An image sensor, comprising:
at least one light filter, used for arranged to filtering infrared light except a particular-wavelength infrared light, wherein the at least one light filter allows visible light and the particular-wavelength infrared light to transmit; and
a color filter located below the at least one light filter, wherein the color filter comprises multiple n-color filters, wherein each filter corresponds to one color, the multiple n-color filters are used for arranged to divideing visible light in incident light into n-color light, wherein n is a positive integer; and
a light-sensitive chip located below the color filter, wherein the light-sensitive chip comprises a signal processing circuit and multiple light-sensitive units one-to-one corresponding to the multiple n-color filters, the multiple light-sensitive units are respectively used for arranged to senseing intensity of light transmitting through the multiple n-color filters and to generateing electric signals corresponding to the light transmitting through the multiple n-color filters, the signal processing circuit is used for configured to processing the electric signals for imaging, and a gain ratio of the signal processing circuit to the electric signals is A1: A2: ...: Ai: ...: Aj: ...: An, wherein i and j are integers greater than or equal to 1 and less than or equal to n, and i≠j,
wherein an intensity transmittance of the multiple n-color filters of the color filter to the particular-wavelength infrared light is M1: M2(A1/A2): ...: Mi(A1/Ai): ...: Mj(A1/Aj): ...: Mn(Al/An), and values of M1, M2, ..., Mi, ..., Mj, ... and Mn are determined according to color cast required by the image sensor.

11. The image sensor according to claim 10, further comprising:
a micro lens located between the light filter and the color filter, used for and arranged to receivinge and converginge the incident light.

12. The image sensor according to claim 10 or 11, wherein the color cast comprises a color cast type.

13. The image sensor according to claim 12, wherein the color cast further comprises a color cast degree.

14. The image sensor according to claim 12 or 13, wherein the Mi value of a filter corresponding to a target color cast type is greater than the Mj value of other filters.

15. The image sensor according to any one of claims 10 to 14, wherein the gain ratio of the signal processing circuit to the electric signals A1: A2: ...: Ai: ...: Aj: ...: An is obtained according to the intensity transmittance of the multiple n-color filters of the color filter to the particular-wavelength infrared light.

16. A monitoring system, comprising:
an electronic device, wherein the electronic device comprises the image sensor according to any one of claims 10 to 15; and
a fill light lamp, wherein the fill light lamp emits the particular-wavelength infrared light.

17. An image sensor, comprising:
a color filter, wherein, for light in infrared wavebands, the color filter is arranged to allow a particular-wavelength infrared light to pass, and the color filter comprises multiple n-color filters, wherein each of the multiple n-color filter corresponds to one color, the multiple n-color filters are arranged to divide visible light in incident light into n-color light, wherein n is a positive integer; and
a light-sensitive chip located below the color filter, wherein the light-sensitive chip comprises a signal processing circuit and multiple light-sensitive units one-to-one corresponding to the multiple n-color filters, the multiple light-sensitive units are respectively used for sensing intensity of light transmitting through the multiple n-color filters and generating electric signals corresponding to the light transmitting through the multiple n-color filters, the signal processing circuit is configured to process the electric signals for imaging, wherein a gain ratio of the signal processing circuit to the electric signals is M1A1: M2A2: ...: MiAi: ...: MjAj: ...: MnAn, and values of the M1, M2, ..., Mi, ..., Mj, ... and Mn are determined according to color cast required by the image sensor, wherein i and j are integers greater than or equal to 1 and less than or equal to n, and i≠j,
wherein an intensity transmittance of the multiple n-color filters of the color filter to the particular-wavelength infrared light is 1: (A1/A2): ...: (A1/Ai): ...: (A1/Aj): ...: (A1/An).

18. The image sensor according to claim 17, further comprising:
a micro lens located above the color filter, wherein the micro lens is arranged to receive and converge the incident light.

19. The image sensor according to claim 7 or 18, wherein the color cast comprises a color cast type.

20. The image sensor according to claim 19, wherein the color cast further comprises a color cast degree.

21. The image sensor according to claim 19 or 20, wherein the Mi value of a filter corresponding to a target color cast type is greater than the Mj value of other filters.

22. The image sensor according to any one of claims 17 to 21, wherein the gain ratio of the signal processing circuit to the electric signals M1A1: M2A2: ...: MiAi: ...: MjAj: ...: MnAn is obtained according to the intensity transmittance of the multiple n-color filters of the color filter to the particular-wavelength infrared light.

23. The image sensor according to claim 18, further comprising:
a light filter located above the micro lens, used for filtering infrared light except the particular-wavelength infrared light.

24. The image sensor according to any one of claims 17 to 22, further comprising:
a light filter located above the color filter, used for filtering infrared light except the particular-wavelength infrared light.

25. A monitoring system, comprising:
an electronic device, wherein the electronic device comprises the image sensor according to any one of claims 17 to 24; and
a fill light lamp, wherein the fill light lamp emits the particular-wavelength infrared light.

26. An image sensor, comprising:
at least one light filter, used for filtering infrared light except particular-wavelength infrared light, wherein the at least one light filter allows visible light and the particular-wavelength infrared light to transmit;
a color filter located below the at least one light filter, wherein the color filter comprises multiple n-color filters, wherein each filter corresponds to one color, the multiple n-color filters are used for dividing visible light in incident light into n-color light, wherein n is a positive integer; and
a light-sensitive chip located below the color filter, wherein the light-sensitive chip comprises a signal processing circuit and multiple light-sensitive units one-to-one corresponding to the multiple n-color filters, the multiple light-sensitive units are respectively used for sensing intensity of light transmitting through the multiple n-color filters and generating electric signals corresponding to the light transmitting through the multiple n-color filters, the signal processing circuit is used for processing the electric signals for imaging, wherein a gain ratio of the signal processing circuit to the electric signals is M1A1: M2A2: ...: MiAi: ...: MjAj: ...: MnAn, and values of the M1, M2, ..., Mi, ..., Mj, ... and Mn are determined according to color cast required by the image sensor, wherein i and j are integers greater than or equal to 1 and less than or equal to n, and i≠j,
wherein an intensity transmittance of the multiple n-color filters of the color filter to the particular-wavelength infrared light is 1: (A1/A2): ...: (A1/Ai): ...: (A1/Aj): ...: (A1/An).

27. The image sensor according to claim 26, further comprising:
a micro lens located between the light filter and the color filter, used for receiving and converging the incident light.

28. The image sensor according to claim 26 or 27, wherein the color cast comprises a color cast type.

29. The image sensor according to claim 28, wherein the color cast further comprises a color cast degree.

30. The image sensor according to claim 28 or 29, wherein the Mi value of a filter corresponding to a target color cast type is greater than the Mj value of other filters.

31. The image sensor according to any one of claims 26 to 30, wherein the gain ratio of the signal processing circuit to the electric signals M1A1: M2A2: ... : MiAi:: ...: MjAj: ...: MnAn is obtained according to the intensity transmittance of the multiple n-color filters of the color filter to the particular-wavelength infrared light.

32. A monitoring system, comprising:
an electronic device, wherein the electronic device comprises the image sensor according to any one of claims 26 to 31; and
a fill light lamp, wherein the fill light lamp emits the particular-wavelength infrared light.
